(19) Europäisches Patentamt
European Patent Office
Office européen des brevets

(11) **EP 3 125 312 A1**

(12) **EUROPEAN PATENT APPLICATION**
published in accordance with Art. 153(4) EPC

(43) Date of publication:
**01.02.2017 Bulletin 2017/05**

(51) Int Cl.:
***H01L 33/22*** *(2010.01)*

(21) Application number: **15768215.4**

(22) Date of filing: **26.03.2015**

(86) International application number:
**PCT/JP2015/059313**

(87) International publication number:
**WO 2015/147135 (01.10.2015 Gazette 2015/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **26.03.2014 JP 2014064235**

(71) Applicant: **JX Nippon Oil & Energy Corporation**
**Chiyoda-ku**
**Tokyo 100-8162 (JP)**

(72) Inventors:
• **SEKI, Takashi**
 **Tokyo 100-8162 (JP)**
• **NISHIMURA, Suzushi**
 **Tokyo 100-8162 (JP)**
• **TORIYAMA, Shigetaka**
 **Tokyo 100-8162 (JP)**
• **TAKAHASHI, Madoka**
 **Tokyo 100-8162 (JP)**

(74) Representative: **Kuhnen & Wacker**
**Patent- und Rechtsanwaltsbüro**
**Prinz-Ludwig-Straße 40A**
**85354 Freising (DE)**

(54) **EPITAXIAL GROWTH SUBSTRATE AND LIGHT-EMITTING ELEMENT USING SAME**

(57) An epitaxial growth substrate includes a base member, and a concave-convex pattern having a plurality of concavities and a plurality of convexities and formed on the base member, wherein: each of the plurality of convexities has an elongated shape which extends while winding (waving) in a plane view; and the plurality of convexities in the concave-convex pattern have extending directions, bending directions and lengths which are non-uniform among the plurality of convexities. There are provided an epitaxial growth substrate which can be produced efficiently and which is capable of improving the light-emitting efficiency of a light-emitting element; and a light-emitting element using the epitaxial growth substrate.

**Fig. 2**

(a)

(b)

**Description**

TECHNICAL FIELD

The present invention relates to an epitaxial growth substrate for epitaxially growing a semiconductor layer, etc., and a light-emitting element (light-emitting device) having an epitaxial growth substrate and a semiconductor layer formed on the epitaxial growth substrate.

BACKGROUND ART

A semiconductor light-emitting element generally includes a light emitting diode (LED), a laser diode (LD), etc., and is widely used for a variety of kinds of light source used for backlight, etc., illumination, a signal (traffic light), a large-sized display, etc.

A light-emitting element having a layer of semiconductor such as a nitride semiconductor is generally constructed by epitaxially growing, on a light-transmitting (translucent) substrate, a buffer layer, a n-type semiconductor layer, an active layer, and a p-type semiconductor layer sequentially, and by forming a n-side electrode and a p-side electrode respectively so that the n-side electrode and the p-side electrode are electrically connected respectively to the n-type semiconductor layer and the p-type semiconductor layer. In this light-emitting element, a light generated in the active layer is allowed to exit to the outside of the element from externally exposed surfaces (upper and side surfaces) of each of the semiconductor layers and from exposed surfaces (back and side surfaces) of the substrate, etc. In such a light-emitting element, if the light generated in the active layer comes into the interface between the semiconductor layer and the electrode, or into the interface between the semiconductor layer and the substrate at an angle not less than a predetermined critical angle, the light propagates inside the semiconductor layer in the lateral direction while being fully reflected in a repeated manner; during the repeated full reflection, a portion of the light is absorbed, and thus the light extraction efficiency is lowered.

In view of the above situation, Patent Literatures 1 and 2 disclose that the light extraction efficiency of the light-emitting element is improved by etching a surface of a substrate on which a semiconductor layer is grown so as to form a concave-convex pattern (concavity and convexity pattern) in the surface of the substrate. Further, Patent Literature 2 discloses that providing such a concave-convex pattern on the surface of the substrate on which a semiconductor layer is grown makes it possible to reduce the dislocation density of the semiconductor layer and to suppress any deterioration in the characteristic of the light-emitting element.

[Citation List]

[Patent Literature]

PATENT LITERATURE 1: Japanese Patent Application Laid-open No. 2010-206230
PATENT LITERATURE 2: Japanese Patent Application Laid-open No. 2001-210598

SUMMARY OF INVENTION

Problem to be Solved by the Invention:

There is such a demand that the semiconductor light-emitting element as described above has further improved light emission efficiency. Further, there is also such a demand that the semiconductor light-emitting element as described above is to be produced with higher production efficiency. In view of the above situation, an object of the present invention is to provide an epitaxial growth substrate (a substrate for epitaxial growth) based on which a light-emitting element such as a semiconductor light-emitting element can be produced more efficiently, and via which the light emitting efficiency of the light-emitting element can be improved, and to provide a light-emitting element using the epitaxial growth substrate.

Solution to the Problem:

According to a first aspect of the present invention, there is provided an epitaxial growth substrate comprising a base member, and a concave-convex pattern having a plurality of (a large number of) concavities and a plurality of convexities and formed on the base member, wherein:

(i) each of the plurality of convexities has an elongated shape which extends while winding (waving) in a plane view; and

(ii) the plurality of convexities in the concave-convex pattern have extending directions, bending directions and lengths which are non-uniform among the plurality of convexities.

In the epitaxial growth substrate, an average pitch of the plurality of concavities and the plurality of convexities may be in a range of 100 nm to 10 $\mu$m.

In the epitaxial growth substrate, the plurality of convexities may have a cross-sectional shape, in a direction orthogonal to the extending directions of the plurality of convexities, which is narrowing from a bottom portion, of each of the plurality of convexities, toward an apex portion of each of the plurality of convexities. Further, a part of the plurality of convexities may have a branched shape.

In the epitaxial growth substrate, since the concave-convex pattern has the above-described characteristics (i) and (ii), a concave-convex cross-sectional shape consequently appears repeatedly under a condition that the concave-convex pattern is cut in any plane orthogonal to a surface of the base member.

In the epitaxial growth substrate, standard deviation of depths of the plurality of convexities and the plurality of concavities in the concave-convex pattern may be in a range of 10 nm to 5 $\mu$m.

In the epitaxial growth substrate, the extending directions of the plurality of convexities may be distributed irregularly in the plane view; and a contour (border line) in the plane view of convexities, among the plurality of convexities, included in a region of unit area of the concave-convex pattern may contain a straight line section in an amount greater than that of a curved line section.

In the epitaxial growth substrate, widths of the convexities in a direction substantially orthogonal in the plane view to the extending directions of the convexities may be constant.

In the epitaxial growth substrate, under a condition that a plurality of sections are formed in the contour in the plane view of the convexities by segmenting the contour by a length which is $\pi$ (circumference ratio; pi) times an average value of widths of the convexities, the curved line section may be a section, among the plurality of sections, in which ratio of a linear distance between both end points in the section to a length, in the contour, between the both end points in the section is not more than 0.75, and the straight line section may be a section which is not the curved line section among the plurality of sections.

In the epitaxial growth substrate, under a condition that a plurality of sections are formed in the contour in the plane view of the convexities by segmenting the contour by a length which is $\pi$ (circumference ratio) times an average value of widths of the convexities, the curved line section may be a section, among the plurality of sections, in which an angle is not more than 120 degrees, the angle being one angle of not more than 180 degrees among two angles defined by a line segment connecting one end point of the section to a middle point of the section and another line segment connecting the other end point of the section to the middle point of the section, and the straight line section may be a section which is not the curved line section among the plurality of sections; and ratio of the curved line section in the plurality of sections may be not less than 70%.

In the epitaxial growth substrate, the extending directions of the plurality of convexities may be distributed irregularly in the plane view; and widths of the plurality of convexities in a direction substantially orthogonal in the plane view to the extending directions of the plurality of convexities may be constant.

In the epitaxial growth substrate, a Fourier-transformed image, obtained by performing a two-dimensional fast Fourier-transform processing on a concavity and convexity analysis image obtained by analyzing the concave-convex pattern with a scanning probe microscope, may show a circular or annular pattern substantially centered at an origin at which an absolute value of wavenumber is 0 $\mu$m$^{-1}$; and the circular or annular pattern may be present within a region in which the absolute value of wavenumber is in a range of not more than 10 $\mu$m$^{-1}$.

The epitaxial growth substrate may have a buffer layer which is formed on a surface, of the base member, having the concave-convex pattern formed therein. Further, the plurality of convexities may be formed of a material different from a material constructing the base member; in this case, the plurality of convexities may be formed of a sol-gel material. Alternatively, the plurality of concavities may be formed of a material same as a material constructing the base member. In particular, the base member may be a sapphire substrate.

According to a second aspect of the present invention, there is provided a light-emitting element comprising a semiconductor layer which is provided on the epitaxial growth substrate as described above, and which includes at least: a first conductivity type layer, an active layer and a second conductivity type layer.

Effects of Invention:

The concave-convex pattern of the epitaxial growth substrate of the present invention has a cross-sectional shape which is formed of relatively gently inclined surfaces, and has the convexities which extend continuously in a ridge-like shape. Accordingly, in a case that the concave-convex pattern is formed by the imprinting method which uses a mold, the mold is less likely to become clogged, thus realizing efficient production. Further, in a case that a layer is allowed to epitaxially grown on the epitaxial growth substrate, since the inclined surfaces of the concave-convex shape are relatively gentle, the epitaxially grown layer can be stacked uniformly on the concave-convex pattern, thereby making it possible to form an epitaxial layer with little defect. Furthermore, since the epitaxial growth substrate of the present invention has a function as a diffraction grating substrate capable of improving the light extraction efficiency, a light-emitting element produced by using this epitaxial growth substrate has a high light emission efficiency. Therefore, the epitaxial growth substrate of the present invention is quite effective for producing a light-emitting element having an excellent light emission efficiency.

BRIEF DESCRIPTION OF DRAWINGS

Figs. 1(a) to 1(c) are each a schematic cross-sectional view of an epitaxial growth substrate of an embodiment.

Fig. 2(a) is an example of an AFM (Atomic Force Microscope) image of a surface of the epitaxial growth substrate of the embodiment, and Fig. 2(b) depicts a cross-sectional profile of the epitaxial growth substrate on a cutting line in the AFM image in Fig. 2(a).
Figs. 3(a) to 3(d) are each a schematic cross-sectional view of an epitaxial growth substrate, of an embodiment, having a buffer layer formed therein.
Figs. 4(a) to 4(d) are views conceptually depicting respective steps in a method for producing the epitaxial growth substrate by a substrate etching method.
Fig. 5 is a flowchart of a method for producing the epitaxial growth substrate by a concavity (recess) etching method.
Figs. 6(a) to 6(e) are views conceptually depicting respective steps in a method for producing the epitaxial growth substrate by the concavity etching method.
Fig. 7 is a view conceptually depicting an example of a situation in a pressing step and a peeling (releasing) step in the method for producing the epitaxial growth substrate by the concavity etching method.
Fig. 8 is a flowchart of a method for producing the epitaxial growth substrate by a peel (release) transfer method.
Figs. 9(a) to 9(e) are views conceptually depicting respective steps in the method for producing the epitaxial growth substrate by the peel transfer method.
Fig. 10 is a view conceptually depicting an example of a situation in a coating (applying) step, a tight contacting (adhering) step and a peeling (releasing) step in the method for producing the epitaxial growth substrate by the peel transfer method.
Figs. 11(a) to 11(e) are views conceptually depicting respective steps in a method for producing the epitaxial growth substrate by a micro-contact method.
Fig. 12 is a schematic cross-sectional view of an optical element of an embodiment of the present invention.
Fig. 13 depicts an example of a plane view-analysis image (black and white image) of an epitaxial growth substrate of an embodiment.
Figs. 14(a) and 14(b) are views for explaining an example of a judging method for making judgment regarding branching of a convexity (convex portion) in a plane view-analysis image.
Fig. 15(a) is a view used for explaining a first defining method for defining a curved line section, and Fig. 15(b) is a view used for explaining a second defining method for defining the curved line section.
Fig. 16 is an AFM image of a surface of a thin film subjected to a solvent annealing processing in an Example 1.

DESCRIPTION OF EMBODIMENTS

In the following, an embodiment of an epitaxial growth substrate, and embodiment of a light-emitting element using the epitaxial growth substrate, a method for producing the epitaxial growth substrate and a method for producing the light-emitting element according to the present invention will be explained, with reference to the drawings.

[Epitaxial growth substrate]

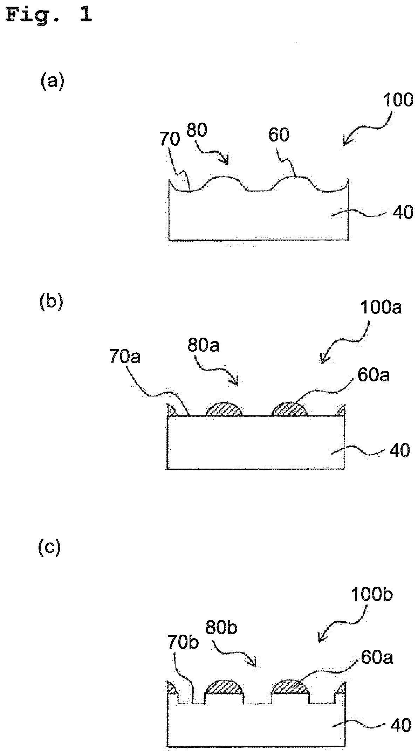

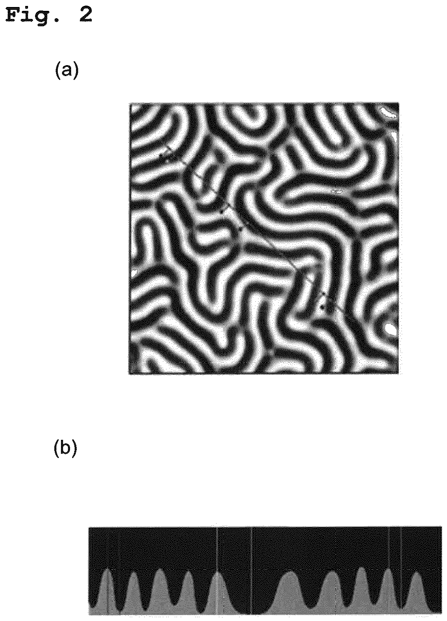

Fig. 1(a) depicts a schematic cross-sectional view of an epitaxial growth substrate 100 of an embodiment. The epitaxial growth substrate 100 of the embodiment has a concave-convex pattern 80 which is formed in a surface of a base member 40, and which has a plurality of convexities 60 and a plurality of concavities 70, as depicted in Fig. 1(a). Fig. 2(a) depicts an example of an AFM image of the epitaxial growth substrate of the embodiment, and Fig. 2(b) depicts a cross-sectional profile of the epitaxial growth substrate on a cutting line in the AFM image in Fig. 2(a).
As the base member 40 for the epitaxial growth substrate 100, it is possible to use a variety of kinds of substrates having the light-transmissivity (translucent property). For example, it is possible to use substrates formed of materials, for example, including: glass; oxide single crystal such as sapphire single crystal ($Al_2O_3$; A-plane, C-plane, M-plane and R-plane), spinel single crystal ($MgAl_2O_4$), ZnO single crystal, $LiAlO_2$ single crystal, $LiGaO_2$ single crystal, MgO single crystal, etc.; Si single crystal; SiC single crystal; SiN single crystal; GaAs single crystal; AlN single crystal; GaN single crystal; boride single crystal such as $ZrB_2$; etc. Among these substrates, the sapphire single crystal substrate and the SiC single crystal substrate are preferred. Note that the plane orientation of the base member is not particularly limited. Further, the base member may be a just substrate having an off-angle of 0 (zero) degrees, or a substrate having an off-angle applied thereto.

The cross-sectional shape of the concave-convex pattern 80 of the epitaxial growth substrate 100 is formed of relatively gently inclined surfaces and constructs a waveform (in the present application, referred to as "waveform structure", as appropriate) upward from the base member 40, as depicted in Fig. 1(a) and Fig. 2(b). Namely, the convexities 60 have a cross-sectional shape which is narrowing from the base portion, of each convexity, located on the side of the base member toward the apex portion of each convexity. In the planar shape of the concave-convex pattern 80, as in Fig. 2(a) depicting an example of an AFM image of the concave-convex pattern 80, the convexities (white portions) extend while winding (waving) in a ridge-like shape, and the extending direction, the winding direction and the extending length of the convexities may be irregular in a plane view. Namely, the convexities have characteristics such that (i) the convexities each have an elongated shape which extends while winding (waving) in a plane view; and (ii) the convexities in the concave-convex pattern have the extending directions, bending directions and lengths which are non-uniform (uneven) among the convexities. Accordingly, the concave-convex pattern 80 is clearly different from a regularly arranged pattern such as stripe, waved stripe, zigzag, etc., or a regularly arranged pattern such as dot-shaped pattern, etc. The concave-convex pattern 80 does not include such a regularly arranged pattern, and can be distinguished, in view of this point, from a pattern, such as a circuit pattern, which has a regularity and/or many linear portions or straight lines, etc. Since the concave-convex pattern 80 has the above-described characteristics, even under a condition that the concave-convex pattern 80 is cut in any plane orthogonal to a surface of the base member 40, the concave-convex cross-sectional shape consequently appears repeatedly. Further, a part (portion) or the entirety of the convexities may be branched at an intermediate portion thereof, in a plane view (see Fig. 2(a)). Note that in Fig. 2(a), the pitch of the convexities appears to be uniform as a whole. Furthermore, in the concave-convex pattern 80, the concavities 70 are defined by the concavities 60, and extend along the convexities 60. Similarly to the convexities 60, the concavities 70 have the extending direction, the winding direction and the extending length which are irregular in a plane view.

In a case that the epitaxial growth substrate is used, for example, as a substrate of a light-emitting element formed of a GaN-based semiconducting material, in order to improve the light extraction efficiency in the light-emitting element, the pitch of the convexities and concavities preferably has a width in the frequency distribution such that the Fourier-transformed image of the concave-convex pattern is annular; further, the concave-convex pattern is preferably an irregular concave-convex pattern in which the orientations of the concavities and convexities have no directionality. In order that the epitaxial growth substrate 100 functions as a diffraction grating improving the light extraction efficiency of the light-emitting element, the average pitch of concavities and convexities is preferably in a range of 100 nm to 10 $\mu$m, and more preferably in a range of 100 nm to 1500 nm. In a case that the average pitch of the concavities and convexities is less than the above-described lower limit, the pitch is too small with respect to the luminous wavelength of the light-emitting element, and the diffraction of the light by the concavities and convexities is less likely to occur. On the other hand, in a case that the average pitch of the concavities and convexities exceeds the above-described upper limit, the diffraction angle is so small that functions as the diffraction grating are more likely to be lost. The average pitch of the concavities and convexities is more preferably in a range of 200 nm to 1200 nm.

The average value of the depth distribution of the concavities and convexities in the concave-convex pattern is preferably in a range of 20 nm to 10 $\mu$m, more preferably in a range of 50 nm to 5 $\mu$m. In a case that the average value of the depth distribution of the concavities and convexities is less than the above-described lower limit, the depth is too small with respect to the luminous wavelength, and there is a fear that any necessary diffraction might not be generated. On the other hand, in a case that the average value of the depth distribution of the concavities and convexities exceeds the above-described upper limit and that a semiconductor layer is stacked on the substrate to thereby form a light-emitting element, the thickness of the semiconductor layer required for flattening the surface of the semiconductor layer becomes great, which in turn makes the time required for producing the light-emitting element to be long. The average value of the depth distribution of the concavities and convexities in the concave-convex pattern is further more preferably in a range of 100 nm to 2 $\mu$m. The standard deviation of the depths of convexities and concavities is preferably in a range of 10 nm to 5 $\mu$m. In a case that the standard deviation of the depths of concavities and convexities is less than the lower limit, the depth is so short relative to the wavelengths of the visible light that the required diffraction is less likely to occur. On the other hand, in a case that the standard deviation of the depths of concavities and convexities exceeds the upper limit, the intensity of diffracted light is likely to become non-uniform. The standard deviation of the depths of convexities and concavities is more preferably within a range of 25 nm to 2.5 $\mu$m.

In the present application, the term "average pitch of concavities and convexities" means an average value of the pitch of concavities and convexities in a case of measuring the pitch of the concavities and convexities (spacing distance between adjacent convex portions or spacing distance between adjacent concave portions) in a surface on which the convexities and concavities are formed. Such an average value of the pitch of concavities and convexities can be obtained as follows. Namely, a concavity and convexity analysis image is obtained by measuring the concavities and convexities on the surface by using a scanning probe microscope (for example, a scanning probe microscope manufactured by HITACHI HIGH-TECH SCIENCE CORPORATION, under the product name of "E-sweep", etc.), under the following measurement conditions, then the distances between randomly selected concave portions or convex portions adjacent to each other are measured at not less than 100 points in the concavity and convexity analysis image, and then the average of the distances is arithmetically calculated and is determined as the average pitch of concavities and convexities.

The measurement conditions are as follows:

Measurement mode: cantilever intermittent contact mode
Material of the cantilever: silicon
Lever width of the cantilever: 40 $\mu$m
Diameter of tip of chip of the cantilever: 10 nm

Further, in the present application, the average value of the depth distribution of concavities and convexities and the standard deviation of the depths of concavities and convexities can be calculated by the following manner. Namely, a concavity and convexity analysis image is obtained by measuring the shape of the concavities and convexities on the surface by using a scanning probe microscope (for example, a scanning probe microscope manufactured by HITACHI HIGH-TECH SCIENCE CORPORATION, under the product name of "E-sweep", etc.). When performing the analysis of the concavities and convexities, the measurement is performed in a randomly selected measurement region of 3 $\mu$m square (vertical: 3 $\mu$m, horizontal: 3 $\mu$m) or in a randomly selected measurement region of 10 $\mu$m square (vertical: 10 $\mu$m, horizontal: 10 $\mu$m) under the above-described conditions. When doing so, data of height of concavities and convexities at not less than 16,384 points (vertical: 128 points x horizontal: 128 points) are obtained within the measurement region, each in nanometer scale. Note that although the number of measurement points is different depending on the kind and/or setting of the measurement device which is used, for example in a case of using the above-described scanning probe microscope manufactured by HITACHI HIGH-TECH SCIENCE CORPORATION, under the product name of "E-sweep" as the measurement device, it is possible to perform the measurement at measurement points of 65,536 points (vertical: 256 points x horizontal: 256 points; namely, the measurement in a resolution of 256 x 256 pixels) within the measurement region of 10 $\mu$m square. Here, in order to improve the accuracy of measurement, the flat processing (flattening) including the primary inclination correction may be applied to the obtained concavity-convexity analysis image. Further, in order to guarantee a sufficient accuracy of measurement in the variety of kinds of analysis regarding the concave-convex shape which will be described later on, it is appropriate that the area of measurement is made to be a square area in which each of the sides has a length not less than 15 times the average value of widths of the convexities included in the area of measurement. Then, with respect to the height of concavities and convexities (unit: nm) measured in such a manner, at first, a measurement point "P" is determined, among all the measurement points, which is the highest from the bottom surface (base) of the base member or the substrate (a surface, of the base member or the substrate, on the side opposite to the surface having the concave-convex pattern formed therein). Then, a plane which includes the measurement point P and which is parallel to the bottom surface of the base member or the substrate is determined as a reference plane (horizontal plane), and a depth value from the reference plane (difference obtained by subtracting, from the value of height from the bottom surface of the base member or the substrate at the measurement point P, the height from the bottom surface of base member or the substrate at each of the measurement points) is obtained as the data of depth of concavities and convexities. Note that such a depth data of the concavities and convexities can be obtained, for example, by performing automatic calculation with software in the measurement device (for example, the above-described scanning probe microscope manufactured by HITACHI HIGH-TECH SCIENCE CORPORATION, under the product name of "E-sweep"), and the value obtained by the automatic calculation in such a manner can be utilized as the data of depth of concavities and convexities.

After obtaining the data of depth of concavity and convexity at each of the measurement points in this manner, the values, which can be calculated by obtaining the arithmetic average value and the standard deviation of the obtained data of depths of concavity and convexity, are adopted as the average value of the depth distribution of concavities and convexities and the standard deviation of the depths of concavities and convexities. In this specification, the average pitch of concavities and convexities and the average value of the depth distribution of concavities and convexities can be obtained via the above-described measuring method, regardless of the material of the surface on which the concavities and convexities are formed.

Further, note that in the present application, the term "irregular concave-convex pattern" includes such a quasi-periodic structure in which a Fourier-transformed image, obtained by performing a two-dimensional fast Fourier-transform processing on a concavity and convexity analysis image obtained by analyzing a concave-convex shape on the surface, shows a circular or annular pattern substantially centered at an origin at which an absolute value of wavenumber is 0 $\mu m^{-1}$, namely, such a quasi-periodic structure in which, although the concavities and convexities have no particular orientation (directionality), the structure has the distribution of the pitches of concavities and convexities (the pitches of the concavities and convexities vary). The circular or annular pattern may be present within a region where the absolute value of wavenumber is in a range of not more than 10 $\mu m^{-1}$ (the absolute value of wavenumber may be in a range of 0.1 $\mu m^{-1}$ to 10 $\mu m^{-1}$, further may be in a range of 0.667 $\mu m^{-1}$ to 10 $\mu m^{-1}$, and preferably may be in a range of 0.833 $\mu m^{-1}$ to 5 $\mu m^{-1}$). The light(s) scattered and/or diffracted by such a concave-convex pattern is (are) a light having a wavelength in a relatively broad band, rather than a light having a single wavelength or a light having a wavelength in a narrow band, and the scattered and/or diffracted light(s) have no directivity, and travel(s) in various directions. Therefore, the substrate having such a quasi-periodic structure is suitable for a substrate used in a light-emitting element such as the LED, provided that the substrate has the concavities and convexities of which pitch distribution or pitch variability enables the substrate diffract visible light.

Note that in the Fourier-transformed image, obtained by performing the two-dimensional fast Fourier-transform processing on the concavity and convexity analysis image, a pattern is observed due to gathering of bright spots in the Fourier-transformed image. Accordingly, the phrase "the Fourier-transformed image shows a circular pattern" means that the pattern of the gathering of bright spots in the Fourier-transformed image looks like a substantially circular; and the phrase further encompasses a case in which a part or portion of the contour of the circular pattern looks like a convex shape or a concave shape. Further, the phrase "the Fourier-transformed image shows an annular pattern" means the pattern of the gathering of the bright spots looks like a substantially annular shape; the phrase further encompasses a case in which the shape of an outer circle and/or inner circle of the ring looks like a substantially circular shape and a case in which a part or portion of the contour of the outer circle and/or the inner circle of the ring looks like a convex shape or a concave shape. Further, the phrase "the circular or annular pattern is present within a region where the absolute value of wavenumber is not more than 10 $\mu m^{-1}$ (the absolute value of wavenumber may be in a range of 0.1 $\mu m^{-1}$ to 10 $\mu m^{-1}$, further may be in a range of 0.667 $\mu m^{-1}$ to 10 $\mu m^{-1}$, and preferably may be in a range of 0.833 $\mu m^{-1}$ to 5 $\mu m^{-1}$)" means that not less than 30% of bright spots forming the Fourier-transformed image are present within a region in which the absolute value of wavenumber is not more than 10 $\mu m^{-1}$ (the absolute value of wavenumber may be in a range of 0.1 $\mu m^{-1}$ to 10 $\mu m^{-1}$, further may be in a range of 0.667 $\mu m^{-1}$ to 10 $\mu m^{-1}$, and preferably may be in a range of 0.833 $\mu m^{-1}$ to 5 $\mu m^{-1}$). In a case that the concave-convex pattern is formed so as to satisfy the above-conditions to thereby use the epitaxial growth substrate of the present embodiment as the substrate for a light-emitting element, it is possible to make the wavelength dependency of a light emitted from the light-emitting element and the directivity (property to emit light with a high intensity in a constant direction) of the light-emitting element to be sufficiently small.

Note that the followings have been revealed with respect to the relationship between the concave-convex pattern and the Fourier-transformed image. Namely, in a case that the concave-convex pattern itself has neither the pitch distribution nor the directivity, the Fourier-transformed image appears to have a random pattern (no pattern). On the other hand, in a case that the concave-convex pattern is entirely isotropic in an XY direction but has the pitch distribution, a circular or annular Fourier-transformed image appears. Further, in a case that the concave-convex pattern has a single pitch, the annular shape appeared in the Fourier-transformed image tends to be sharp.

The two-dimensional fast Fourier transform processing on the concavity and convexity analysis image can be easily performed by electronic image processing by use of a computer equipped with software for the two-dimensional fast Fourier transform processing.

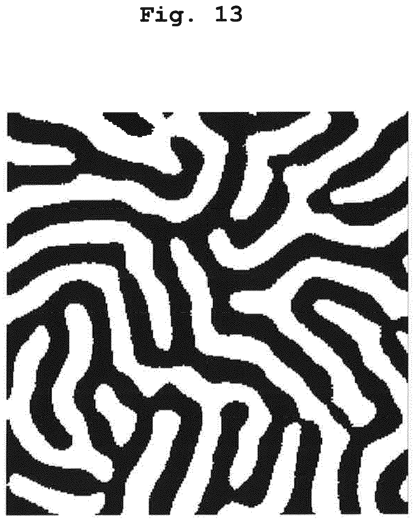

Note that a plane-view analysis image (black and white image) as depicted in Fig. 13 can be obtained by processing the concavity and convexity analysis image such that the convexities are shown in white (as white portions) and the concavities are shown in black (as black portions). Fig. 13 depicts an example of the plane view-analysis image in a measurement region of the epitaxial growth substrate 100 according to the present embodiment.

The widths of the convexities (portions shown in white, white portions) are referred to as "widths of convexities". The average value of such widths of the convexities can be calculated: by selecting any 100 or more locations (portions) from the convexities in the plane view-analysis image; by measuring, regarding each of the selected 100 or more locations (portions) in the convexities, the length from a boundary up to the other boundary on the opposite side in a direction substantially orthogonal, in a plane view, to the extending direction of the convexity; and then by obtaining the arithmetic mean of the lengths of the boundary to the other boundary for the selected 100 or more locations (portions) in the convexities.

Note that the values at the randomly sampled locations in the convexities in the plane view-analysis image are used in the calculation of the average value of the widths of the convexities, as described above. It is allowable, however, not to use values at positions at which the convexity is branched. Whether or not a certain area or region of the convexity is an area relating to the branching may be judged, for example, based on whether or not the certain region of the convexity extends in an amount (length) of not less than a predetermined extent (value). More specifically, the judgement may be made based on whether or not the ratio of the extending length of the certain region with respect to the width of the certain region is not less than a constant ratio (for example, 1.5 or more).

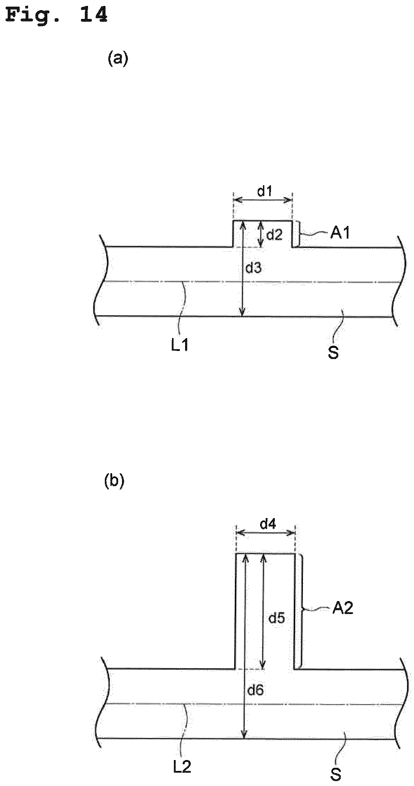

An explanation will be given about an example of a judging method for judging whether or not a region, which protrudes from an intermediate position of a convexity extending in a certain direction, in a direction substantially orthogonal to the axis of extension of the convexity, is branching, with reference to Fig. 14. Here, the axis of extension of the convexity is such a virtual axis of the convexity that is along the extending direction of the convexity defined by the shape of the outer edge of the convexity, provided that the region as the judgment target region as to whether or not the region is branched is removed from (considered as not belonging to) the convexity. More specifically, the axis of extension of the convexity is a line drawn so as to pass through the approximately center point of the width, of the convexity, that is orthogonal to the extending direction of the convexity. Each of Figs. 14(a) and 14(b) is a view for schematically explaining an example of the determining method, with only a portion of a convexity in a plane view-analysis image being sampled and depicted, wherein an area "S" represents a convexity. In Figs. 14(a) and 14(b), it is presumed that regions A1 and A2 each protruding from an intermediate position in the convexity are determined as the judgment target region as to whether or not the protruded region is a branching. In this case, axes of extension L1 and L2 are defined, each as a line passing through the approximately center point of the width, of one of the convexities, that is orthogonal to the extending direction of the convexity, provided that the regions A1 and A2 are removed from (considered as not belonging to) the convexities, respectively. Such axes of extension may be defined by means of image processing by a computer, or by an operator performing the analytical operation, or defined both by the image processing of the computer and the manual operation by the operator. In Fig. 14(a), the region A1 protrudes in a direction orthogonal to the axis of extension L1 from an intermediate position in the convexity which extends along the axis of extension L1. In Fig. 14(b), the region A2 protrudes in a direction orthogonal to the axis of extension L2 from an intermediate position in the convexity which extends along the axis of extension L2. Note that regarding regions which obliquely protrude in the directions orthogonal to the axis of extension L1 and L2, respectively, it is possible to judge as to whether or not such obliquely protruding regions are each a branching, based on reasoning similar to those regarding the regions A1 and A2 as described below.

According to the above-described judging method, the ratio of a extending length d2 of the region A1 relative to a width d1 of the region A1 is approximately 0.5 (less than 1.5), and thus the region A1 is judged to be not a region regarding the branching. In this case, a length d3 passing the region A1 and in the direction orthogonal to the axis of extension L1 is made to be one of the measured values for calculating the average value of the widths of the convexities. On the other hand, the ratio of a extending length d5 of the region A2 relative to a width d4 of the region A2 is approximately 2 (not less than 1.5), and thus the region A2 is judged to be a region regarding the branching. In this case, a length d6 passing the region A2 and in the direction orthogonal to the axis of extension L2 is not made to be one of the measured values for calculating the average value of the widths of the convexities.

In the epitaxial growth substrate 100 of the present embodiment, the widths of the convexities, in the direction substantially orthogonal in the plane view to the extending direction of the convexities in the concave-convex pattern 80, may be constant. Whether or not the widths of the convexities are constant can be judged based on the widths of the 100 or more locations in the convexities obtained in the above-described measurement. Specifically, the average value of the widths of the convexities and the standard deviation of the widths of convexities are calculated from the widths of the 100 or more locations in the convexities. Then, a value calculated by dividing the standard deviation of the widths of the convexities by the average value of the widths of the convexities (the standard deviation of the widths of the convexities / the average value of the widths of the convexities) is defined as the coefficient of variation of the widths of the convexities. The coefficient of variation takes a smaller value as the widths of the convexities are constant (as the variation of the widths is smaller). Accordingly, it is possible to judge whether or not the widths of the convexities are constant based on whether or not the coefficient of variation is not more than a predetermined value. For example, in a case that the coefficient of variation is not more than 0.25, it is possible to define that the widths of the convexities are constant.

Further, in the epitaxial growth substrate 100 according to the present embodiment, the extending direction of the convexities (white portions) included in the concave-convex pattern is distributed irregularly in the plane view, as depicted in Fig, 13. Namely, the convexities compose such an irregular shape in which the convexities extend in an irregular direction, rather than a stripe shape composed of stripes regularly arranged side by side or a dot shape composed of regularly arranged dots. Further, in the measurement region, namely in a predetermined region of the concave-convex pattern, the contour (border line) in the plane view of the convexities, included in a region of unit area of the concave-convex pattern, contains a straight line section in an amount greater than that of a curved line section.

In the present embodiment, the phrase "contain(s) a straight line section in an amount greater than that of a curved line section" means that the concave-convex pattern is provided not to be as such a concave-convex pattern in which winding sections or segments have a major presence in the all sections in the contour of the convexities. Whether or not the contour in the plane view of the convexities, included in a region of unit area of the concave-convex pattern, contains a straight line section in an amount greater than that of a curved line section can be judged by using any one of the following two methods for making judgement between line segments as indicated below.

EP 3 125 312 A1

<First method for defining curved line section>

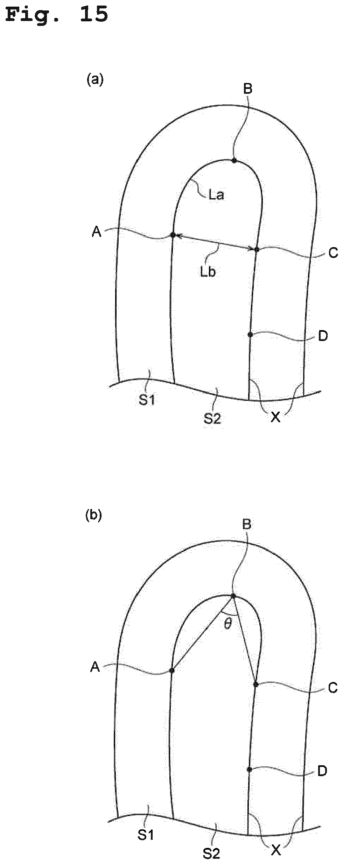

In a first method for defining a curved line section, the curved line section is defined as follows. Namely, under a condition that a plurality of sections are formed in a contour in the plane view of convexities by segmenting the contour by a length which is π (circumference ratio) times the average value of widths of the convexities, the curved line section is defined to be a section, among the plurality of sections, wherein the ratio of the linear distance between the both end points in the section to the length, in the contour, between the both end points in the section is not more than 0.75; further, the straight line section is defined to be a section which is different from the curved line section among the plurality of sections, namely a section in which the above-described ratio is more than 0.75. In the following, an explanation will be given about an example of a procedure for judging whether or not the contour in the plane view of the convexities contains the straight line section in an amount greater than that of the curved line section, with reference to Fig. 15(a). Fig. 15(a) is a view depicting a part of the plane view-analysis image of the concave-convex pattern in which the concavities are depicted in white, for convenience. In Fig. 15(a), a region S1 represents a convexity and a region S2 represents a concavity.

<Procedure 1-1>

One convexity is selected from convexities inside the measurement region. An arbitrary point on a contour X of the selected convexity is determined as a start point. In Fig. 15(a), as an example, a point A is set as the start point. Reference points are set on the contour X of the convexity, with a predetermined spacing distance from the start point. Here, the predetermined distance is a length that is π (circumference ratio; pi)/2 times the average value of the widths of the convexities. In Fig. 15(a), as an example, points B, C, D are sequentially set.

<Procedure 1-2>

After the points A to D are set as the reference points on the contour X of the convexity, a section as a judgement target section is set. Here, the start point and an end point are the reference points, and a section including a reference point, among the reference points, as an intermediate point between the start point and the end point is set as the judgement target section. In the example depicted in Fig. 15(a), in a case that the point A is set as the start point of the section, the point C which is the secondly set point counting from the point A becomes the end point of the section. Here, the spacing distance from the point A is set to be the length that is π/2 times the average value of the widths of the convexities. Accordingly, the point C is a point apart from the point A, along the contour X, by the length that is as long as π times the average value of the widths of the convexities. Similarly, in a case that the point B is set as the start point of the section, the point D which is the secondly set point counting from the point B becomes the end point of the section. Note that, here, provided that the target section is set in the order of the setting of the points, and that the point A is the firstly set point. Namely, at first, a section of the point A to the point C (section AC) is made to be the target for the processing. Then, a length La, in the contour X of the convexity, connecting the point A and the point C and a linear distance Lb between the point A and the point C are measured.

<Procedure 1-3>

By using the length La and the linear distance Lb measured in the procedure 1-2, the ratio of the linear distance Lb relative to the length La (Lb/La) is calculated. In a case that the ratio is not more than 0.75, the point B as the middle point in the section AC of the contour X of the convexity is judged as the point present in a curved line section. On the other hand, in a case that the ratio is more than 0.75, the point B is judged as the point present in a straight line section. Note that in the example depicted in Fig. 15(a), the ratio (Lb/La) is not more than 0.75, and thus the point B is judged as the point present in the curved line section.

<Procedure 1-4>

With respect to cases in each of which one of the respective points set in the procedure 1-1 is selected as the start point, the procedure 1-2 and the procedure 1-3 are executed.

<Procedure 1-5>

With respect to all the convexities within the measurement region, the procedures 1-1 to 1-4 are executed.

9

<Procedure 1-6>

In a case that with respect to all the points set for all the convexities within the measurement region, the ratio of the points judged as being present in the straight line section is not less than 50% of all the points, it is judged that the contour in the plane view of convexities included in the measurement region contains the straight line section in an amount greater than that of the curved line section. On the other hand, in a case that with respect to all the points set for all the convexities within the measurement region, the ratio of the points judged as being present in the straight line section is less than 50% of all the points, it is judged that the contour in the plane view of convexities included in the measurement region contains the curved line section in an amount greater than that of the straight line section.

The processing in the procedures 1-1 to 1-6 may be executed by measurement function provided on a measurement device, may be executed by activating any analytic software different from the measurement device, etc., or may be executed manually.

Note that the processing in which the points are set on the contour of each of the convexities in the procedure 1-1 may be finished when any more point cannot be set, for example, as the procedures make one lap in the convexity, or go out of the measurement region, etc. Further, regarding a section located outside of the firstly set point and the lastly set point, the ratio (Lb/La) cannot be calculated. Accordingly, such a section may be made as non-target section for the judgement. Furthermore, regarding a convexity in which the length of the contour is less than $\pi$ times the average of the widths of the convexities may be made as non-target section.

<Second method for defining curved line section>

In a second method for defining a curved line section, the curved line section is defined as follows. Namely, under a condition that a plurality of sections are formed in the contour, in plane view of the convexities, by segmenting the contour by a length which is $\pi$ (circumference ratio) times the average value of the widths of the convexities, the curved line section is defined to be a section, among the plurality of sections, wherein an angle is not more than 120 degrees, the angle being a smaller angle (angle of not more than 180 degrees) among two angles defined by a line segment (line segment AB) connecting one end point (point A) of the section to a middle point (point B) of the section and another line segment (line segment CB) connecting the other end point (point C) of the section to the middle point (point B) of the section. Further, the straight line section is defined to be a section which is not the curved line section among the plurality of sections, namely, as a section wherein the above-described angle is greater than 120 degrees. In the following, an explanation will be given about an example of a procedure for judging whether or not the contour in the plane view of the convexities contains the straight line section in an amount greater than that of the curved line section, with reference to Fig. 15(b). Fig. 15(b) is a view depicting a part of the plane view-analysis image of the concave-convex pattern that is same as that depicted in Fig. 15(a).

<Procedure 2-1>

One convexity is selected from a plurality of convexities inside the measurement region. An arbitrary point on a contour X of the selected convexity is determined as a start point. In Fig. 15(b), as an example, a point A is set as the start point. Reference points are set on the contour X of the convexity, with a predetermined spacing distance from the start point. Here, the predetermined distance is a length that is $\pi$ (circumference ratio; pi)/2 times the average value of the widths of the convexities. In Fig. 15(b), as an example, points B, C, D are sequentially set.

<Procedure 2-2>

After the points A to D are set as the reference points on the contour X of the convexity, a section as a judgement target section is set. Here, the start point and an end point are the reference points, and a section including a reference point, among the reference points, as an intermediate point between the start point and the end point is set as the judgement target section. In the example depicted in Fig. 15(b), in a case that the point A is set as the start point of the section, the point C which is the secondly set point counting from the point A becomes the end point of the section. Here, the spacing distance from the point A is set to be the length that is $\pi/2$ times the average value of the widths of the convexities. Accordingly, the point C is a point apart from the point A, along the contour X, by the length that is as long as $\pi$ times the average value of the widths of the convexities. Similarly, in a case that the point B is set as the start point of the section, the point D which is the secondly set point counting from the point B becomes the end point of the section. Note that, here, provided that the target section is set in the order of the setting of the points, and that the point A is the firstly set point. Namely, at first, a section of the point A to the point C (section AC) is made to be the target for the processing. Then, an angle $\theta$ is measured, the angle $\theta$ being one angle which is smaller (angle of not more than 180 degrees) among two angles defined by the line segment AB and the line segment CB.

<Procedure 2-3>

In a case that the angle θ is not more than 120 degrees, the point B is judged as the point present in a curved line section. On the other hand, in a case that the angle θ is greater than 120 degrees, the point B is judged as the point present in a straight line section. Note that in the example depicted in Fig. 15(b), the angle θ is not more than 120 degrees, and thus the point B is judged as the point present in the curved line section.

<Procedure 2-4>

With respect to cases in each of which one of the respective points set in the procedure 2-1 is selected as the start point, the procedure 2-2 and the procedure 2-3 are executed.

<Procedure 2-5>

With respect to all the convexities within the measurement region, the procedures 2-1 to 2-4 are executed.

<Procedure 2-6>

In a case that with respect to all the points set for all the convexities within the measurement region, the ratio of the points judged as being present in the straight line section is not less than 70% of all the points, it is judged that the contour in the plane view of convexities included in the measurement region contains the straight line section in an amount greater than that of the curved line section. On the other hand, in a case that with respect to all the points set for all the convexities within the measurement region, the ratio of the points judged as being present in the straight line section is less than 70% of all the points, it is judged that the contour in the plane view of convexities included in the measurement region contains the curved line section in an amount greater than that of the straight line section.

The processing in the procedures 2-1 to 2-6 may be executed by measurement function provided on a measurement device, may be executed by activating any analytic software different from the measurement device, etc., or may be executed manually.

Note that the processing in which the points are set on the contour of each of the convexities in the procedure 2-1 may be finished when any more point cannot be set, for example, as the procedures make one lap in the convexity, or go out of the measurement region, etc. Further, regarding a section located outside of the firstly set point and the lastly set point, the angle θ cannot be calculated. Accordingly, such a section may be made as non-target section for the judgement. Furthermore, regarding a convexity in which the length of the contour is less than π times the average of the widths of the convexities may be made as non-target section.

As described above, by using any one of the first and second defining methods for defining the curved section, it is possible to make judgement regarding the measurement region as to whether the contour in the plane view of convexities included in the measurement region contains the straight line section in an amount greater than that of the curved line section. Note that regarding the concave-convex pattern 80 of a certain epitaxial growth substrate, the judgment as to "whether or not the contour in the plane view of convexities included in a region of unit area contains the straight line section in an amount greater than that of the curved line section" may be performed by judging one measurement region, which is randomly sampled (selected, extracted) among the regions of the concave-convex pattern 80 of the epitaxial growth substrate 100, or may be performed by performing an overall judgement regarding the judgment results in a plurality of different measurement regions of the concave-convex pattern 80 in a same epitaxial growth substrate 100. In such a case, for example, one judgement results, of which number is greater than that of the other judgement results among the judgement results regarding the plurality of different measurement regions, may be adopted as the measurement result regarding "whether or not the contour in the plane view of convexities included in a region of unit area contains the straight line section in an amount greater than that of the curved line section".

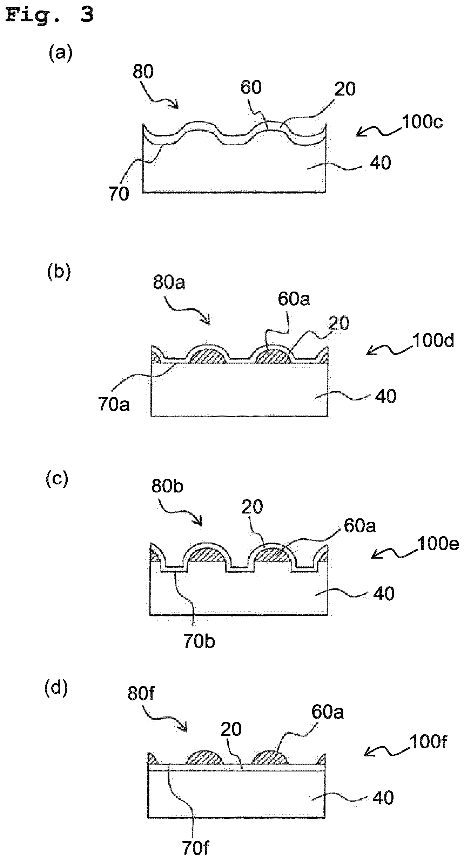

In each of the epitaxial growth substrate 100 depicted in Fig. 1(a) and an epitaxial growth substrate 100c as depicted in Fig. 3(a) which will be described later on, areas, in a surface having the concave-convex pattern formed therein, in which the depth of the concavities and convexities (concave-convex depth) is not more than the average value of the depth distribution of the concavities and convexities are referred to as convexities 60 of the concave-convex pattern, and areas, in the surface having the concave-convex pattern formed therein, in which the depth of the concavities and convexities (concave-convex depth) exceeds the average value of the depth distribution of the concavities and convexities are referred to as concavities 70 of the concave-convex pattern.

In the epitaxial growth substrate 100 depicted in Fig. 1(a), the concave-convex pattern 80 is formed by the concave-convex shape imparted in the surface of the base member 40. It is also allowable that a concave-convex pattern 80a is formed of convexities 60a which are formed so as to project from a surface of the base member 40 and areas (concavities 70a) in which the surface of the base member 40 is exposed and which are defined by (between) the concavities 60a, as in an epitaxial growth substrate 100a of an embodiment depicted in Fig. 1(b); alternatively, it is allowable that a concave-convex pattern 80b is formed of convexities 60a which are formed so as to project from a surface of the base member 40 and areas in which the surface of the base member 40 is concaved or recessed(concavities 70b: a surface of portions of the base member at each of which the thickness of the base member is thinned), as in an epitaxial growth substrate 100b of an embodiment depicted in Fig. 1(c). It is preferred that the convexities 60a in each of the epitaxial growth substrates 100a and 100b are formed of an inorganic material in view of the heat-resistance.

Each of the epitaxial growth substrates of the embodiments may be provided with a buffer layer 20 on the surface of the concave-convex pattern 80, 80a or 80b, as in the epitaxial growth substrates 100c, 100d and 100e depicted in Figs. 3(a) to 3(c), respectively. Further, it is also allowable that a buffer layer 20 is formed on the base member 40 as in an epitaxially growth substrate 100f as depicted in Fig. 3(d), that convexities 60a are formed on the buffer layer 20 so as to project from the surface of the buffer layer 20, and that areas (concavities 70f) at which a surface of the buffer layer 20 is exposed are defined between the convexities 60a, thereby forming a concave-convex pattern 80f. In a case of allowing a semiconductor layer to be epitaxially grown on the surface of each of the epitaxial growth substrates 100c, 100d, 100e and 100f of the embodiments, the buffer layer 20 accommodates or decreases the lattice mismatch (the difference in the lattice constant) between the base member 40 and the semiconductor layer, thereby making it possible to form a semiconductor layer having a high crystallinity. In a case of using the epitaxial growth substrate 100c, 100d, 100e or 100f of the embodiment so as to allow a GaN-based semiconductor layer to be epitaxially grown on the epitaxial growth substrate 100c, 100d, 100e or 100f of the embodiment, the buffer layer can be composed of $Al_xGa_{1-x}N$ ($0 \leq x \leq 1$); and the buffer layer is not limited to a single layer structure, but may be a multi-layer structure in which two or more layers having different compositions are stacked. The layer thickness (thickness) of the buffer layer 20 is preferably in a range of 1 nm to 100 nm.

The concave-convex pattern 80 of the epitaxial growth substrate 100 of the present embodiment has a cross-sectional shape which is formed of relatively gently inclined surfaces, and has the convexities which extend continuously in a ridge-like shape. Accordingly, in a case that the concave-convex pattern 80 is formed by the imprinting method which uses a mold, the mold is less likely to become clogged, thus realizing efficient production. Further, in a case that the epitaxial growth substrate 100 of the embodiment is provided with the buffer layer 20 formed on the concave-convex pattern 80, the buffer layer 20 can be formed uniformly and with little defect, since the concave-convex pattern 80 of the epitaxial growth substrate 100 of the present embodiment has the cross-sectional shape which is formed of the relatively gently inclined surfaces.

Furthermore, in a case of allowing a layer to epitaxially grown on the epitaxial growth substrate 100, it is possible to obtain the following advantages. Namely, since the inclined surfaces of the concave-convex shape are relatively gentle, the epitaxially grown layer can be stacked uniformly on the concave-convex pattern 80, thereby making it possible to form an epitaxial layer with little defect. Moreover, the concave-convex pattern has such an irregular shape in which the orientations of the concavities and convexities have no orientation (directionality); thus even if any defect due to the pattern is generated, it is possible to form an epitaxially grown layer which is uniform and has no anisotropy in the defect.

Further in a case of producing a light-emitting element by allowing a semiconductor layer to be epitaxially grown on the epitaxial growth substrate 100, it is possible to obtain the following advantages. Firstly, the epitaxial growth substrate of the embodiment has high light extraction efficiency, and thus a light-emitting element produced by using the epitaxial growth substrate has a high light emission efficiency. Secondly, since light(s) diffracted by the epitaxial growth substrate of the embodiment has no directivity, the light(s) extracted from the light-emitting element produced by using the epitaxial growth substrate have no directivity, and travel(s) in every direction. Thirdly, the production time of the light-emitting element can be shortened for the following reason. Namely, in a case of producing a light-emitting element by using a substrate having a concave-convex pattern, it is necessary to stack the semiconductor layer until the concave-convex shape of the concave-convex pattern is filled with the semiconductor layer such that the surface of the semiconductor layer is flattened. The epitaxial growth substrate of the embodiment has sufficient light extraction efficiency at the concave-convex depth in the order of several tens of nanometers. Accordingly, the stacking thickness of the semiconductor layer can be smaller on the epitaxial growth substrate of the embodiment than on a conventional substrate having a concave-convex pattern of which concave-convex depth is in the order of sub-micron to micrometer as described in Patent Literature 1. This makes it possible to shorten the growth time of the semiconductor layer, and thus to shorten the production time for producing the light-emitting element.

[Method for Producing Epitaxial Growth Substrate]

A method for producing an epitaxial growth substrate will be explained. The epitaxial growth substrate of the embodiment can be produced, for example, by using a mold for transferring a concave-convex pattern (mold for concave-convex pattern transfer; will be explained in the following) and with the substrate etching method, the concavity (recess) etching method, the micro-contact method, the peel transfer method, etc. In the following, at first, the mold for concave-convex pattern transfer and a method for producing the mold for concave-convex pattern transfer will be explained, and then the substrate etching method, the concavity (recess) etching method, the micro-contact method and the peel transfer method will be explained.

(0) Mold for concave-convex pattern transfer

Examples of the mold for concave-convex pattern transfer used for producing an epitaxial growth substrate include, for example, a metal mold or a film-shaped resin mold (resin film mold) produced in a method as will be described later on. The resin forming the resin mold also includes rubber such as natural rubber or synthetic rubber. The mold has a concave-convex pattern (convexity and concavity pattern) on a surface thereof, and the cross-sectional shape of the concave-convex pattern is formed of relatively gently inclined surfaces and constructs a waveform structure. The concave-convex pattern of the mold has such a planar shape in which convexities are extending continuously in a ridge-like shape, and in which the concavities may be branched at an intermediate portion thereof.

An explanation will be given about an exemplary method for producing the mold for concave-convex pattern transfer. A master block pattern for forming the concave-convex pattern of the mold is manufactured first. It is preferred that the concave-convex pattern of the master block be formed by a method of utilizing the self-organization or self-assembly (micro phase separation) of a block copolymer by heating, as described in International Publication No. WO2012/096368 of the applicants of the present invention (hereinafter referred to as "BCP (Block Copolymer) thermal annealing method" as appropriate), or a method of utilizing the self-organization or self-assembly of a block copolymer under a solvent atmosphere, as described in International Publication No. WO2013/161454 of the applicants of the present invention (hereinafter referred to as "BCP solvent annealing method" as appropriate), or a method of heating and cooling a vapor deposited film on a polymer film to form concavities and convexities of wrinkles on a surface of polymer, as disclosed in International Publication No. WO2011/007878 A1 of the applicants of the present invention (hereinafter referred to as "BKL (Buckling) method" as appropriate). In a case that the pattern is formed by the BCP thermal annealing method or the BCP solvent annealing method, although any material can be used as the material for forming the pattern, the material is preferably a block copolymer composed of a combination of two selected from the group consisting of: a styrene-based polymer such as polystyrene; polyalkyl methacrylate such as polymethyl methacrylate; polyethylene oxide; polybutadiene; polyisoprene; polyvinylpyridine; and polylactic acid. The pattern formed by the self-organization of these materials preferably has a horizontal cylinder structure (structure wherein cylinders are oriented horizontally relative to a base material) as described in WO2013/161454, or a vertical lamella structure (structure in which lamellae are oriented vertically relative to a base material) as described in "Macromolecules", Vol. 47, pp. 2 (2014), among which the vertical lamella structure is more preferred since deeper concavities and convexities are formed. Further, the concave-convex pattern obtained by the solvent annealing process may be subjected to etching by irradiation with energy rays represented by ultraviolet rays such as excimer UV light, or etching by a dry etching method such as RIE (reactive ion etching), ICP etching, etc. Furthermore, the concave-convex pattern which has been subjected to such an etching may be subjected to the heating process. Moreover, based on the concave-convex pattern formed by the BCP thermal annealing method or the BCP solvent annealing method, it is possible to form a concave-convex pattern in which concavities and convexities have further deeper depth, with a method as described in "Advanced Materials", vol. 24, pp. 5688-5694 (2012), "Science", vol. 322, pp. 429 (2008), etc. Namely, a base material layer formed of $SiO_2$, Si, etc. is coated with a block copolymer, and a self-organization structure of the block copolymer is formed by the BCP thermal annealing method or the BCP solvent annealing method. Then, one of the segments of the block copolymer is selectively etched away. The other segment, as the remaining segment, is used as a mask for the etching of the base material layer, thereby forming a groove (concavity or concave portion) having a desired depth in the base material layer. In a case that the mold for concave-convex pattern transfer which is produced is used in the substrate etching method, the concavity etching method, the micro-contact method or the peel transfer method which will be described later on, the average value of the depth distribution of the concavities and convexities in the concave-convex pattern is preferably in a range of 20 nm to 10 $\mu$m, more preferably in a range of 50 nm to 5 $\mu$m. In a case that the average value of the depth distribution of the concavities and convexities is less than the above-described lower limit, the depth is too small with respect to the luminous wavelength, and there is a fear that any necessary diffraction might not be generated. On the other hand, in a case that the average value of the depth distribution of the concavities and convexities exceeds the above-described upper limit and that a semiconductor layer is stacked on the substrate to thereby form a light-emitting element, the thickness of a semiconductor layer required for flattening the surface of the semiconductor layer becomes great, which in turn makes the time required for producing the light-emitting element to be long. The average value of the depth distribution of the concavities and convexities in the concave-convex pattern is further more preferably in a range of 100 nm to 2 $\mu$m. In a case that the mold for concave-convex pattern transfer which is produced is used in the micro-contact method which will be described later on, the average value of the depth distribution of the concavities and convexities in the concave-convex pattern is preferably a value in a range of 1 time to 10 times the average pitch of the concave-convex pattern to be formed. In a case that the average value of the depth distribution of concavities and convexities of the mold is smaller than the lower limit, the coating film of the sol-gel material is formed also to a portion on the base member that is different from the intended portion(s) on the base member, in some cases. On the other hand, in a case that the average value of the depth distribution of concavities and convexities of the mold is greater than the upper limit, there is such a possibility that the shape of the mold might be deformed in the adhering step of the micro-contact method which will be described later on, that the pattern transferred onto the base member might collapse, and that any desired pattern might not be obtained.

Instead of using the above-described BCP thermal annealing method, the BKL method and the BCP solvent annealing method, the photolithography method may be used to form the concave-convex pattern. Other than these, the concave-convex pattern of the master block can be manufactured, for example, also by microfabrication or fine-processing methods including a cutting (cutting and processing) or machining method, an electron-beam direct imaging method, a particle beam processing method, a scanning probe processing method, and a fine-processing method using the self-organization or self-assembly of fine particles, etc.

After forming the master block with the concave-convex pattern by means of the BCP thermal annealing method, the BKL method or the BCP solvent annealing method, etc., further, a mold to which the pattern is transferred can be formed by an electroforming method or the like, as follows. At first, a seed layer functioning as an electroconductive layer for an electroforming process can be formed on the master block, which has the pattern thereon, by means of non-electrolytic plating, sputtering, vapor deposition, or the like. The thickness of the seed layer is preferably not less than 10 nm to uniformize a current density during the subsequent electroforming process, and thereby making the thickness of a metal layer accumulated by the subsequent electroforming process be uniform. As the material of the seed layer, it is possible to use, for example, nickel, copper, gold, silver, platinum, titanium, cobalt, tin, zinc, chrome, gold-cobalt alloy, gold-nickel alloy, boron-nickel alloy, solder, copper-nickel-chromium alloy, tin-nickel alloy, nickel-palladium alloy, nickel-cobalt-phosphorus alloy, or alloy thereof. Subsequently, a metal layer is accumulated on the seed layer by the electroforming (electroplating). The entire thickness of the metal layer including the thickness of the seed layer can be, for example, in a range of 10 $\mu$m to 30000 $\mu$m. As the material of the metal layer accumulated by the electroforming, it is possible to use any of the metal species as described above which can be used as the seed layer. Considering ease of the subsequent processes for forming the mold such as pressing with respect to the resin layer, releasing (peeling-off), and cleaning (washing), the formed metal layer desirably has appropriate hardness and thickness.

The metal layer including the seed layer obtained as described above is released (peeled off) from the master block having the concave-convex structure to obtain a metal substrate. As the releasing method, the metal layer may be peeled off physically, or the materials composing the pattern of the master block may be dissolved to be removed by using an organic solvent dissolving them, such as toluene, tetrahydrofuran (THF), and chloroform. When the metal substrate is peeled off from the master block, a remaining material component on the metal substrate can be removed by cleaning. As the cleaning method, it is possible to use wet cleaning using a surfactant etc., or dry cleaning using ultraviolet rays and/or plasma. Alternatively, for example, it is allowable to use an adhesive agent or a bonding agent such that the remaining material component is caused to attach or adhere to the adhesive agent or the bonding agent then is removed. Accordingly, the metal substrate which can be obtained in such a manner and to which the pattern has been transferred from the master block may be used as the mold for concave-convex pattern transfer of the embodiment.

A flexible mold such as a film-shaped mold (film mold) can be manufactured by using the obtained metal substrate and by transferring the concave-convex structure (pattern) of the obtained metal substrate to a film-shaped supporting substrate. For example, after a curable resin is applied on the supporting substrate (the supporting substrate is coated with the curable resin) to form a resin layer, the resin layer is cured while the concave-convex structure of the metal substrate is being pressed against the resin layer. The supporting substrate is exemplified, for example, by base members made of inorganic materials such as glass, quartz (quartz glass), silicon, etc.; base members made of organic materials such as silicone resin, polyethylene terephthalate (PET), polyethylene naphthalate (PEN), polycarbonate (PC), cycloolefin polymer (COP), polymethyl methacrylate (PMMA), polystyrene (PS), polyimide (PI), polyarylate, etc.; and metallic materials such as nickel, copper, aluminum, etc. The thickness of the supporting substrate may be in a range of 1 $\mu$m to 500 $\mu$m.

The curable resin can be exemplified by various resins including, for example, monomers, oligomers, and polymers of those based on epoxy, acryl, methacryl, vinyl ether, oxetane, urethane, melamine, urea, polyester, polyolefin, phenol, cross-linking type liquid crystal, fluorine, silicone, polyamide, etc. The thickness of the curable resin is preferably in a range of 0.5 $\mu$m to 500 $\mu$m. In a case that the thickness is less than the lower limit, heights of the concavities and convexities formed on the surface of the cured resin layer are likely to be insufficient. On the other hand, in a case that the thickness exceeds the upper limit, the influence of volume change of the resin upon curing is likely to be so large that there is such a possibility that the formation of the shape of the concavities and convexities might be unsatisfactory.

As a method for coating the supporting substrate with the curable resin, it is possible to adopt, for example, various coating methods such as the spin coating method, spray coating method, dip coating method, dropping method, gravure printing method, screen printing method, relief printing method, die coating method, curtain coating method, ink-jet method, and sputtering method. Further, although the condition for curing the curable resin varies depending on the kind of the resin to be used, the curing temperature is preferably for example in a range of the room temperature to 250°C, and the curing time is preferably in a range of 0.5 minute to 3 hours. Alternatively, a method may be employed in which the curable resin is cured by being irradiated with energy ray such as ultraviolet light or electron beam. In such a case, the amount of the irradiation is preferably in a range of 20 mJ/cm$^2$ to 5 J/cm$^2$.

Subsequently, the metal substrate is detached from the curable resin layer after the curing. The method for detaching the metal substrate is not limited to a mechanical releasing (exfoliating or peeling off) method, and a publicly known method can be adopted. Accordingly, a film-shaped resin mold, which can be obtained in such a manner and which has the cured resin layer having the concavities and convexities and formed on the supporting substrate, may be used as the mold for concave-convex pattern transfer of the embodiment.

Further, it is possible to coat the concave-convex structure (pattern) of the metal substrate obtained in the above-described manner with a rubber-based resin material, to cure the coated resin material, and to release the cured resin material from the metal substrate, so as to manufacture a rubber mold having the concave-convex pattern of the metal substrate transferred thereto. The obtained rubber mold may be used as the mold for concave-convex pattern transfer of the embodiment. Silicone rubber or a mixture or copolymer of silicone rubber and another material is particularly preferably used as the rubber-based resin material. The usable silicone rubber is exemplified, for example, by polyorganosiloxane, cross-linking type polyorganosiloxane, a polyorganosiloxane/polycarbonate copolymer, a polyorganosiloxane/polyphenylene copolymer, a polyorganosiloxane/polystyrene copolymer, polytrimethyl-silylpropyne, poly-4-methyl pentene, etc. The silicone rubber is more inexpensive than other resin materials; has superior heat resistance, high heat conductivity, and elasticity; and the silicone rubber is less likely to be deformed under a high temperature condition. Thus, the silicone rubber is suitable for the transfer process for concave-convex pattern under the high temperature condition. Further, since the silicone rubber-based material has high permeability of gas and water vapor, a solvent and water vapor of a material to be subjected to transfer can go through or permeate the silicone rubber material easily. Therefore, the silicone rubber-based material is suitable for such a case of using the rubber mold for the purpose of transferring the concave-convex pattern to a sol-gel material, as will be described later on. Further, it is preferred that the surface free energy of rubber-based material be not more than 25 mN/m. With this, it is possible to obtain a superior mold-releasing property during the transfer of the concave-convex pattern of the rubber mold to the coating film on the base member, thereby making it possible to prevent any transfer failure. The rubber mold may have, for example, a length in a range of 50 mm to 1000 mm, a width in a range of 50 mm to 3000 mm, and a thickness in a range of 1 mm to 50 mm. In a case that the thickness of the rubber mold is less than the lower limit, there is such a fear that the strength of the rubber mold might be small, which in turn might lead to such a fear that rubber mold might be damaged during the handling of the rubber mold. On the other hand, in a case that the thickness of the rubber mold exceeds the upper limit, it might be difficult to release or peel off the rubber mold from the master mold during the manufacture of the rubber mold. Further, a mold-release treatment may be performed on the surface of the concave-convex pattern of the rubber mold as needed.

(1) Substrate Etching Method

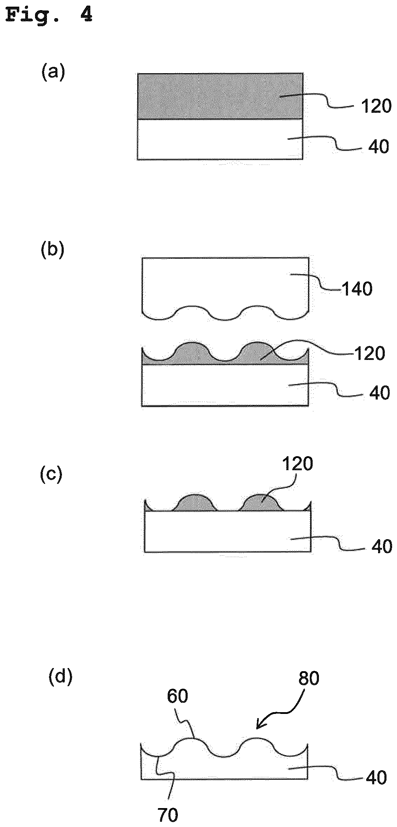

In the substrate etching method, an epitaxial growth substrate is produced by using a general nano-imprint method. Namely, as depicted in Figs. 4(a) to 4(d), a surface of a substrate 40 is coated with a resist for nano-imprint (nano-imprint resist), which has a curing effect by being subject to irradiation of heat or ultraviolet ray, so as to form a resist layer 120 (see Fig. 4(a)). A mold 140 having the above-described concave-convex pattern is pressed against the resist layer 120, to thereby transfer the concave-convex pattern of the mold 140 onto the resist layer 120 (see Fig. 4(b)). Since the resist material remains as residual in the concavities of the resist layer 120 after the mold is released (peeled off) from the resist layer 120, such a remaining resist material is removed by, for example, being subjected to an etching with an O$_2$ gas, etc., thereby allowing the surface of the base member 40 to be exposed at portions corresponding to the concavities of the resist layer 120 (see Fig. 4(c)). Next, the exposed portions of the base member 40 are subjected to etching (see Fig. 4(d)). In this procedure, by performing the etching of the resist layer 120 and the etching of the base layer 40 at the same time under such a condition (the etching gas composition) that the ratio of the etching rates of the resist layer 120 and the base member 40 are 1:1, the shape of the concave-convex pattern of the resist layer 120 can be transferred to the base member 40. In a case that a sapphire substrate is used as the base member 40, the etching of the base member 40 can be performed, for example, by RIE using gas containing BCl$_3$, etc. In such a manner, it is possible to produce an epitaxial growth substrate 100 formed with the concave-convex pattern 80 which is composed of convexities (convex portions) 60 and concavities (concave portions) 70.

In the nano-imprint method, generally, when the mold is released (peeled off) from the resist layer, the mold is released in a state that the concavities of the mold is clogged with the resist layer (clogging of the mold occurs) in some cases, which in turn makes it difficult to perform the pattern transfer at a high speed. However, since the concave-convex pattern of the mold which is used in the embodiment has the cross-sectional shape which is formed of the relatively gently inclined surfaces and the planar shape in which convexities extend continuously in the ridge-like shape, such a clogging of the mold is less likely to occur, which in turn makes it possible to reduce the frequency of cleaning (washing) or exchanging the mold. Therefore, in the present producing method, it is possible to realize a continuous production of the epitaxial growth substrate at a high speed and for a long period of time, and to suppress the production cost of the epitaxial growth substrate.

(2) Concavity Etching Method

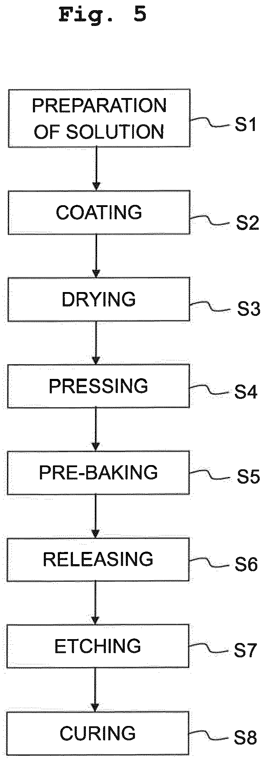

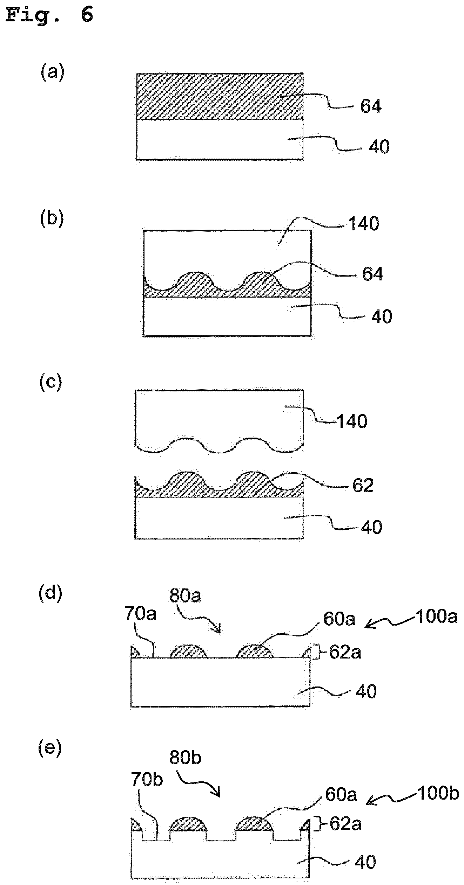

In the above-described substrate etching method, the exposed portions of the base member are subjected to the etching. On the other hand, in the concavity etching method, concavities, of a concave-convex structure, formed on the base member is etched and to expose the substrate at portions corresponding to the concavities. As depicted in Fig. 5, a method for producing an epitaxial growth substrate by the concavity etching method mainly includes: a solution preparation step S1 of preparing a sol-gel material; a coating step S2 of coating a base member with the prepared sol-gel material (applying the prepared sol-gel material on the base member) to thereby form a coating film of the sol-gel material on the base member; a drying step S3 for drying the coating film of the sol-gel material with which the base member is coated; a pressing step S4 for pressing a mold having a transfer pattern formed therein against the coating film which has been dried for a predetermined time; a pre-baking (pre-calcination) step S5 for subjecting the coating film pressed with the mold to the pre-baking; a releasing step (peeling step) S6 of releasing (peeling off) the mold from the coating film; an etching step S7 of removing (etching away) concavities of the coating film; and a curing step S8 of curing the coating film. In the following, the respective steps S1 to S8 will be explained successively, with reference to Figs. 6(a) to 6(e).

<Sol-gel material solution preparation step>

Firstly, a solution of sol-gel material (inorganic material) is prepared. As the sol-gel material, it is allowable to use, in particular, sol-gel material of silica, a titanium (Ti)-based material, a material based on indium tin oxide (ITO), ZnO, $ZrO_2$, $Al_2O_3$, etc. For example, in a case that convexities formed of silica are to be formed on the base member by the sol-gel method, metal alkoxide (silica precursor) is prepared as the sol-gel material. As the silica precursor, it is possible to use, for example: tetraalkoxide monomers represented by tetraalkoxysilane such as tetramethoxysilane (TMOS), tetraethoxysilane (TEOS), tetra-i-propoxysilane, tetra-n-propoxysilane, tetra-i-butoxysilane, tetra-n-butoxysilane, tetra-sec-butoxysilane, tetra-t-butoxysilane, etc.; trialkoxide monomers represented by trialkoxysilane such as methyl trimethoxysilane, ethyl trimethoxysilane, propyl trimethoxysilane, isopropyl trimethoxysilane, phenyl trimethoxysilane, methyl triethoxysilane (MTES), ethyl triethoxysilane, propyl triethoxysilane, isopropyl triethoxysilane, phenyl triethoxysilane, methyl tripropoxysilane, ethyl tripropoxysilane, propyl tripropoxysilane, isopropyl tripropoxysilane, phenyl tripropoxysilane, methyl triisopropoxysilane, ethyl triisopropoxysilane, propyl triisopropoxysilane, isopropyl triisopropoxysilane, phenyl triisopropoxysilane, tolyltriethoxysilane, etc.; dialkoxide monomers represented by dialkoxysilane such as dimethyl dimethoxysilane, dimethyl diethoxysilane, dimethyl dipropoxysilane, dimethyl diisopropoxysilane, dimethyl di-n-butoxysilane, dimethyl di-i-butoxysilane, dimethyl di-sec-butoxysilane, dimethyl di-t-butoxysilane, diethyl dimethoxysilane, diethyl diethoxysilane, diethyl dipropoxysilane, diethyl diisopropoxysilane, diethyl di-n-butoxysilane, diethyl di-i-butoxysilane, diethyl di-sec-butoxysilane, diethyl di-t-butoxysilane, dipropyl dimethoxysilane, dipropyl diethoxysilane, dipropyl dipropoxysilane, dipropyl diisopropoxysilane, dipropyl di-n-butoxysilane, dipropyl di-i-butoxysilane, dipropyl di-sec-butoxysilane, dipropyl di-t-butoxysilane, diisopropyl dimethoxysilane, diisopropyl diethoxysilane, diisopropyl dipropoxysilane, diisopropyl diisopropoxysilane, diisopropyl di-n-butoxysilane, diisopropyl di-i-butoxysilane, diisopropyl di-sec-butoxysilane, diisopropyl di-t-butoxysilane, diphenyl dimethoxysilane, diphenyl diethoxysilane, diphenyl dipropoxysilane, diphenyl diisopropoxysilane, diphenyl di-n-butoxysilane, diphenyl di-i-butoxysilane, diphenyl di-sec-butoxysilane, diphenyl di-t-butoxysilane, etc. Further, it is also possible to use alkyltrialkoxysilane and dialkyldialkoxysilane in each of which an alkyl group has carbon numbers of C4 to C18. It is also allowable to use metal alkoxide such as: monomers having vinyl group such as vinyltrimethoxysilane, vinyltriethoxysilane, etc.; monomers having epoxy group such as 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, etc.; monomers having styryl group such as p-styryltrimethoxysilane, etc.; monomers having methacrylic group such as 3-methacryloxypropylmethyldimethoxysilane, 3-methacryloxypropyltrimethoxysilane, 3-methacryloxypropylmethyldiethoxysilane, 3-methacryloxypropyltriethoxysilane, etc.; monomers having acrylic group such as 3-acryloxypropyltrimethoxysilane, etc.; monomers having amino group such as N-2-(aminoethyl)-3-aminopropylmethyldimethoxysilane, N-2-(aminoethyl)-3-aminopropyltrimethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, etc.; monomer having ureide group such as 3-ureidopropyltriethoxysilane, etc.; monomers having mercapto group such as 3-mercaptopropylmethyldimethoxysilane, 3-mercaptopropyltrimethoxysilane, etc.; monomers having sulfide group such as bis(triethoxysilylpropyl) tetrasulfide, etc.; monomers having isocyanate group such as 3-isocyanatopropyltriethoxysilane, etc.; polymers obtained by polymerizing the foregoing monomers in small amounts; and composite materials characterized in that functional group and/or polymer is/are introduced into a part of the material as described above. Further, a part of or all of the alkyl group and the phenyl group of each of these compounds may be substituted with fluorine. Further, examples of the silica precursor include metal acetylacetonate, metal carboxylate, oxychloride, chloride, and mixtures thereof. The silica precursor, however, is not limited to these. In addition to Si, examples of the metal species include Ti, Sn, Al, Zn, Zr, In, and mixtures thereof, but are not limited thereto. It is also possible to use any appropriate mixture of precursors of the oxides of the above metals. Further, it is also allowable to add a surfactant to these materials so as to form a mesoporous concave-convex structure therein. Furthermore, it is possible to use, as the silica precursor, a silane coupling agent having, in its molecule, a hydrolysis group having the affinity and the reactivity with silica and an organic functional group having the water-repellence. For example, there are exemplified silane monomer such as n-octyltriethoxysilane, methyltriethoxysilane, methyltrimethoxysilane, etc.; vinylsilane such as vinyltriethoxysilane, vinyltrimethoxysilane, vinyltris(2-methoxyethoxy)silane, vinylmethyldimethoxysilane, etc.; methacrylsilane such as 3-methacryloxypropyltriethoxysilane, 3-methacryloxypropyltrimethoxysilane, etc.; epoxysilane such as 2-(3,4-epoxycyclohexyl)ethyltrimethoxysilane, 3-glycidoxypropyltrimethoxysilane, 3-glycidoxypropyltriethoxysilane, etc.; mercaptosilane such as 3-mercaptopropyltrimethoxysilane, 3-mercaptopropyltriethoxysilane, etc.; sulfursilane such as 3-octanoylthio-1-propyltriethoxysilane, etc.; aminosilane such as 3-aminopropyltriethoxysilane, 3-aminopropyltrimethoxysilane,
N-(2-aminoethyl)-3-aminopropyltrimethoxysilane,
N-(2-aminoethyl)-3-aminopropylmethyldimethoxysilane,
3-(N-phenyl)-aminopropyltrimethoxysilane, etc.; polymers obtained by polymerizing the monomers as described above; and the like.

In a case that a mixture of TEOS and MTES is used as the solution of the sol-gel material, the mixture ratio thereof can be, for example, 1:1 in a molar ratio. The sol-gel material produces amorphous silica by being subjected to the hydrolysis and polycondensation reaction. An acid such as hydrochloric acid or an alkali such as ammonia is added in order to adjust the pH of the solution as a synthesis condition. The pH is preferably not more than 4 or not less than 10. Water may be added to perform the hydrolysis. The amount of water to be added can be not less than 1.5 times, with respect to the amount of metal alkoxide species, in the molar ratio.

Examples of a solvent of the sol-gel material include alcohols such as methanol, ethanol, isopropyl alcohol (IPA), butanol, etc.; aliphatic hydrocarbons such as hexane, heptane, octane, decane, cyclohexane, etc.; aromatic hydrocarbons such as benzene, toluene, xylene, mesitylene, etc.; ethers such as diethyl ether, tetrahydrofuran, dioxane, etc.; ketones such as acetone, methyl ethyl ketone, isophorone, cyclohexanone, etc.; ether alcohols such as butoxyethyl ether, hexyloxyethyl alcohol, methoxy-2-propanol, benzyloxyethanol, etc.; glycols such as ethylene glycol, propylene glycol, etc.; glycol ethers such as ethylene glycol dimethyl ether, diethylene glycol dimethyl ether, propylene glycol monomethyl ether acetate, etc.; esters such as ethyl acetate, ethyl lactate, γ-butyrolactone, etc.; phenols such as phenol, chlorophenol, etc.; amides such as N,N-dimethylformamide, N,N-dimethylacetamide, N-methylpyrrolidone, etc.; halogen-based solvents such as chloroform, methylene chloride, tetrachloroethane, monochlorobenzene, dichlorobenzene, etc.; hetero-element containing compounds such as carbon disulfide, etc.; water; and mixture solvents thereof. Especially, ethanol and isopropyl alcohol are preferable. Further, a mixture of water and ethanol, and a mixture of water and isopropyl alcohol are also preferable.

As an additive of the solution of sol-gel material, it is possible to use polyethylene glycol, polyethylene oxide, hydroxypropylcellulose, and polyvinyl alcohol for viscosity adjustment; alkanolamine such as triethanolamine, β-diketone such as acetylacetone, β-ketoester, formamid, dimetylformamide, and dioxane, etc., as a solution stabilizer. Further, it is possible to use, as an additive to the solution of sol-gel material, a material which generates an acid or alkali by being irradiated with light such as energy rays represented by ultraviolet rays such as excimer UV light. By adding such a material, the solution of sol-gel material can be cured by being irradiated with light.

<Coating step>

As depicted in Fig. 6(a), a surface of the base member 40 is coated with the solution of sol-gel material (inorganic material) prepared as described above, so as to form a coating film 64 of the sol-gel material. As the coating method, it is possible to use any coating method including, for example, a bar coating method, a spin coating method, a spray coating method, a dip coating method, a die coating method, an ink-jet method, etc. In view of the fact that a base member having a relatively large area (size) can be coated uniformly with the sol-gel material and that the coating can be completed quickly before the sol-gel material cures (forms a gel), the bar coating method, the die coating method, and the spin coating method are preferred.

The thickness of the coating film 64 is preferably not less than 500 nm. Note that it is allowable to perform a surface treatment for the base member 40 or to provide an easy-adhesion layer on the base member 40 so as to improve the adhesion property of the base member 40.

<Drying step>

After the coating of the base member with the sol-gel material, the base member may be kept (held) in the atmospheric air or under reduced pressure in order to evaporate the solvent contained in the coating film 64. In a case that the holding time of the base member is short, the viscosity of the coating film 64 is too low to transfer the concave-convex pattern to the coating film 64. On the other hand, in a case that the holding time of the base member is too long, the polymerization reaction of the precursor proceeds and the viscosity of the coating film 64 becomes too high, which in turn makes it impossible to transfer the concave-convex pattern to the coating film 64. Further, after the coating of the base member with the sol-gel material, the polymerization reaction of the precursor proceeds as the evaporation of the solvent proceeds, and the physical property such as the viscosity of sol-gel material also changes in a short time. From the viewpoint of the stability of concave-convex pattern formation, it is preferred that drying time which enables a good pattern transfer has a sufficiently wide range. The range of the drying time which enables a good pattern transfer can be adjusted by the drying temperature (holding temperature), the drying pressure, the kind of sol-gel material, the ratio of mixed sol-gel materials, the solvent amount used at the time of preparation of the sol-gel material (concentration of sol-gel material), etc.

<Pressing step>

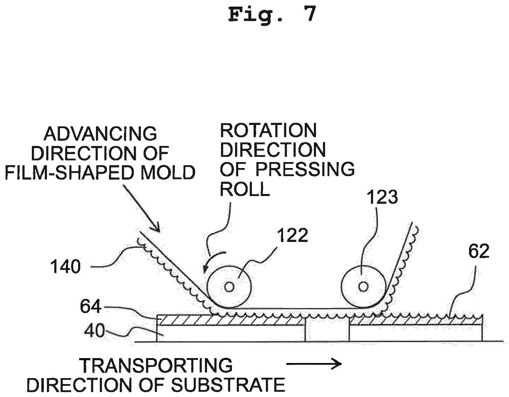

Next, as depicted in Fig. 6(b), a mold 140 is overlapped with and pressed against the coating film 64, thereby transferring a concave-convex pattern of the mold 140 onto the coating film 64 of the sol-gel material. Although the above-described mold for concave-convex pattern transfer can be used as the mold 140, it is preferred to use a film-shaped mold having softness or flexibility. In this situation, a pressing roll may be used to press the mold 140 against the coating film 64 formed of the sol-gel material. The roll process using the pressing roll has the following advantages over the pressing system. In the roll process using the pressing roll, for example, the period of time during which the mold and the coating film are brought in contact with each other is short, and hence it is possible to prevent any deformation or collapse of pattern which would be otherwise caused by the difference in thermal expansion coefficient among the mold, the base member, and a stage on which the base member is placed, etc.; it is possible to prevent the generation of bubbles of gas in the pattern due to the bumping of the solvent in the sol-gel material solution or to prevent any trace or mark of gas from remaining; it is possible to make the transfer pressure and the releasing force (peeling force) to be small owing to the line contact with the base member (coating film), thereby making it possible to easily handle a base member with larger area; and no bubble is included during the pressing. Further, the base member may be heated while the mold is being pressed thereto. As depicted in Fig. 7 as an example of the case of using the pressing roll to press the mold against the coating film of the sol-gel material, the concave-convex pattern of a film-shaped mold 140 can be transferred to the coating film 64 on the base member 40 by sending the film-shaped mold 140 between the pressing roll 122 and the base member 40 which is being transported immediately below the pressing roll 122. Namely, when the film-shaped mold 140 is pressed against the coating film 64 with the pressing roll 122, the surface of the coating film 64 on the base member 40 is coated (covered) with the film-shaped mold 140 while the film-shaped mold 140 and the base member 40 are synchronously transported. In this situation, by rotating the pressing roll 122 while pressing the pressing roll 122 against the back surface (surface on the side opposite to the surface in which the concave-convex pattern is formed) of the film-shaped mold 140, the film-shaped mold 140 moves with the base member 40 while being brought into tight contact with (while being adhered to) the base member 40. Note that, in order to send the long film-shaped mold 140 toward the pressing roll 122, such a configuration is convenient to feed and use the film-shaped mold 140 directly off from a film roll around which the long film-shaped mold 140 is wound.

<Pre-baking step>

After the mold 140 is pressed against the coating film 64 of the sol-gel material, the coating film may be subjected to pre-baking. The pre-baking promotes gelation of the coating film 64 to solidify the pattern, which in turn allows the pattern to be less likely to be collapsed during releasing or peeling of the mold 140. In a case that the pre-baking is performed, heating is preferably performed at a temperature in a range of the room temperature to 300°C in the atmosphere. Note that, however, it is not necessarily required to perform the pre-baking. On the other hand, in a case that the material generating an acid or alkali by being irradiated with a light such as ultraviolet ray is added to the sol-gel material solution, it is allowable for example to irradiate the energy ray represented by ultraviolet ray including the excimer UV light onto the coating film 64, rather than performing the pre-baking for the coating film 64.

<Releasing step>

After the pressing with the mold 140 or the pre-baking for the coating film 64 of the sol-gel material, the mold 140 is released or peeled off from a coating film (concave-convex structure 62) of the sol-gel material having the concavities and convexities formed therein, as depicted in Fig. 6(c). As the method for releasing the mold 140, a publicly known releasing method can be adopted. The mold 140 may be released while being heated. In this case, gas generated from the concave-convex structure 62 is allowed to escape, thereby preventing any generation of bubbles in the concave-convex structure 62. In a case that the roll process is used, the releasing force (peeling force) may be smaller than that in the pressing system using a plate-shaped mold, and it is possible to easily release the mold 140 from the concave-convex structure 62 without allowing the sol-gel material to remain in the mold 140. In particular, since the pressing is performed while the concave-convex structure 62 is being heated, the reaction progresses easily, which in turn facilitates the releasing of the mold 140 from the concave-convex structure 62 immediately after the pressing. Further, in order to improve the releasing property (peeling property) of the mold 140, a peeling roll (releasing roll) may be used. As depicted in Fig. 7, a peeling roll (releasing roll) 123 is disposed on the downstream side of the pressing roll 122, and the peeling roll 123 rotates and supports the film-shaped mold 140 while urging the film-shaped mold 140 toward the coating film 64. With this configuration, it is possible to maintain a state that the film-shaped mold 140 is attached to the coating film 64 as long as a distance between the pressing roll 122 and the peeling roll 123 (for a certain period of time). Then, a path of the film-shaped mold 140 is changed so that the film-shaped mold 140 is pulled up above the peeling roll 123 on the downstream side of the peeling roll 123, thereby peeling off (releasing) the film-shaped mold 140 from the coating film in which concavities and convexities are formed (concave-convex structure 62). The above-described pre-baking or heating for the coating film 64 may be performed during a period in which the film-shaped mold 140 is attached to the coating film 64. Note that in a case of using the peeling roll 123, the releasing of the mold 140 becomes easier by releasing the mold 140 from the coating film 64 (concave-convex structure 62) while heating the coating film 64, for example, at a temperature in a range of the room temperature to 300°C.

<Etching step>

After releasing the mold, a film of the sol-gel material is present in the concavities of the concave-convex structure 62 (regions or areas in the concave-convex structure 62 at each of which the thickness of the concave-convex structure 62 is thin), as depicted in Fig. 6(c). Therefore, the sol-gel material in the concavities of the concave-convex structure 62 is etched away to be removed, thereby exposing the surface of the base member 40 at the concavities of the concave-convex structure 62 and forming convexities 60a on the base member 40, as depicted in Fig. 6(d). The etching may be performed by a reactive ion etching (RIE) using a fluorine-based gas such as $CHF_3$, $SF_6$, etc. Alternatively, the etching may be performed by a wet etching using BHF, etc. In the etching step, since the entirety of the concave-convex structure 62 including not only the concavities but also the convexities thereof is etched, the etching is stopped when the concavities of the concave-convex structure 62 are etched so that the surface of the base member is exposed in areas thereof corresponding to the concavities of the concave-convex structure 62 and convexities 60a of a predetermined size are formed on the base member 40. In such a manner, the areas (concavities 70a) in which the surface of the base member 40 is exposed are defined between the convexities 60a formed of the sol-gel material. A concave-convex structure 62a after the etching is formed of the plurality of convexities 60a formed of the sol-gel material. Note that in a case of performing the etching by the dry etching such as the RIE, etc., the exposed surface of the base member is roughened (damaged). Accordingly, it is allowable to perform a post-processing for the base member with a phosphoric acid-based liquid medicine, etc.

<Curing step>

After the etching step, the concave-convex structure 62a (convexities 60a) formed of the sol-gel material is cured. The convexities 60a can be cured by being subjected to the main baking. The hydroxyl group, etc., contained in silica (amorphous silica) constructing the convexities 60a is desorbed or eliminated (subjected to the leaving) by the main baking, and the convexities 60a are further hardened or solidified. The main baking is preferably performed at a temperature in a range of 600°C to 1200°C for a duration of time in a range of about 5 minutes to about 6 hours. In such a manner, the convexities 60a are cured, thereby making it possible to form the epitaxial growth substrate 100 in which the concave-convex structure 62a (convexities 60a) and the concavities 70a formed on the base member 40 construct a concave-convex pattern 80a. In this situation, in a case that the convexities 60a are made of silica, silica is amorphous, crystalline, or in a mixture state of the amorphous and the crystalline, depending on the baking temperature and/or the baking time. On the other hand, in a case that a material, which generates an acid or alkali by being irradiated with a light such as ultraviolet ray, is added to the sol-gel material solution, the convexities 60a can be cured by irradiation with an energy ray represented by ultraviolet ray including the excimer UV light, rather than baking the convexities 60a.

Note that it is allowable to carry out either one of the curing step and the etching step first. In a case of performing the etching step after the curing step, at first, the concave-convex structure formed of the sol-gel material is cured in the curing step, and then the concavities of the concave-convex structure which have been cured are etched to be removed in the etching step, thereby exposing the portions or areas, in the surface of the base member, corresponding to the concavities.

Furthermore, it is allowable to perform hydrophobic treatment for the surface of the convexities 60a. As the method for the hydrophobic treatment, it is allowable to use any known method for the hydrophobic treatment; for example, regarding a silica surface, it is possible to perform a hydrophobic treatment for the silica surface with dimethyl dichlorosilane, trimethyl alkoxysilane, etc.; it is allowable to use a hydrophobic treatment method for the silica surface with a trimethylsilylating agent such as hexamethyldisilazane, etc., and a silicone oil; or to use a method for surface treatment for the silica surface with metal oxide powder using supercritical carbon dioxide.

Further, as depicted in Fig. 6(e), it is allowable to etch the exposed portions in the surface of the base member which has been exposed in the etching step so as to form concavities (concave portions) 70b in the base member 40. With this, it is possible to form an epitaxial growth substrate 100b in which a concave-convex pattern 80b is composed of a concave-convex structure 62a (convexities 60a) and the concavities 70b. In the epitaxial growth substrate 100b, since the concavities 70b are formed in the base member 40, the depth of concavities and convexities of the concave-convex pattern can be made greater than the substrate 100a for which the etching is not performed for the base member 40. In a case that a sapphire substrate is used as the base member 40, the etching of the base member 40 can be performed, for example, by RIE using gas containing $BCl_3$, etc.

The concave-convex pattern of the mold 140 which is used in the concavity etching method has the cross-sectional shape which is formed of the relatively gently inclined surfaces and the planar shape in which convexities extend continuously in the ridge-like shape. Accordingly, similarly to the substrate etching method, the clogging of the mold is less likely to occur, which in turn makes it possible to reduce the frequency of cleaning (washing) or exchanging the mold. Therefore, in the present producing method, it is possible to realize a continuous production of the epitaxial growth substrate at a high speed and for a long period of time, and to suppress the production cost of the epitaxial growth substrate.

As compared with a method for producing the epitaxial growth substrate in which the surface of the base member is formed to have concavities and convexities to thereby form a concave-convex pattern, as in the substrate etching method, the method for producing the epitaxial growth substrate by the concavity etching method can shorten the time for producing the epitaxial growth substrate. In the method for producing the epitaxial growth substrate wherein the concavities and convexities are directly formed on the surface of the base member, the base member needs to be etched to such an extent corresponding to the depth of concavities and convexities of the concave-convex pattern to be formed. On the other hand, in the concavity etching method, it is sufficient that after releasing (peeling off) the mold, the sol-gel material remaining in the concavities of the concave-convex structure is etched away.

Furthermore, since the roll process can be applied to the concavity etching method as described above, the epitaxial growth substrate can be produced continuously and at a high speed. Further, since the concavity etching method does not use the photolithography method, it is possible to reduce the production cost of the epitaxial growth substrate and to reduce the load to the environment.

(3) Peel Transfer Method

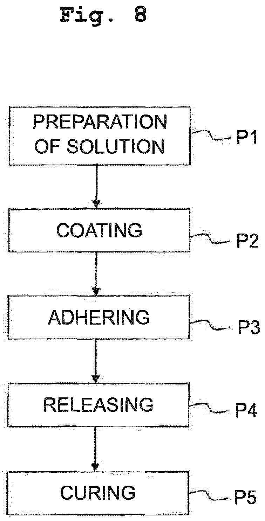

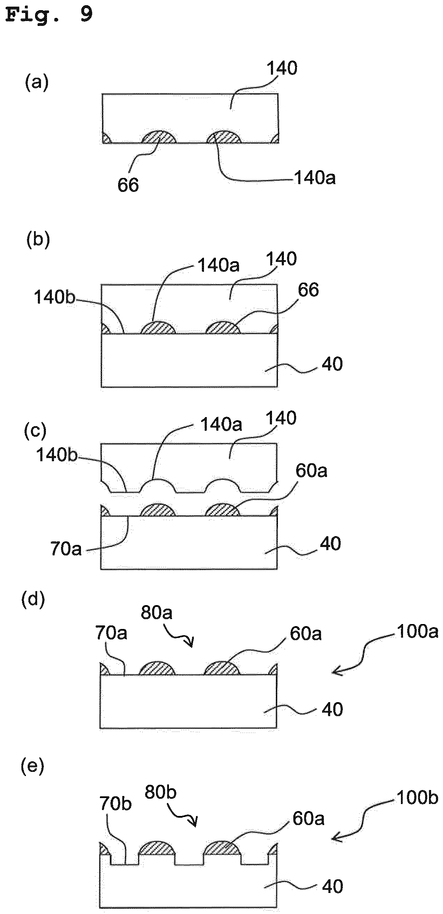

The method for producing an epitaxial growth substrate by the peel transfer method mainly includes, as depicted in Fig. 8: a solution preparation step P1 of preparing a sol-gel material; a coating step P2 of coating a mold with the prepared sol-gel material (applying the prepared sol-gel material on the mold) to thereby form a coating film of the sol-gel material; an adhering step P3 of adhering the sol-gel material, with which the mold is coated, to a base member; releasing step (peeling step) P4 of releasing (peeling off) the mold from the coating film; and a curing step P5 of curing the coating film. In the following, the respective steps P1 to P5 will be explained successively, with reference to Figs. 9(a) to 9(e).

<Sol-gel material solution preparation step>

Firstly, a solution of sol-gel material (inorganic material) is prepared. The preparation of the solution of the sol-gel material may be performed with a method similar to that used in the sol-gel material solution preparation step in the concavity etching method as described above.

<Coating step>

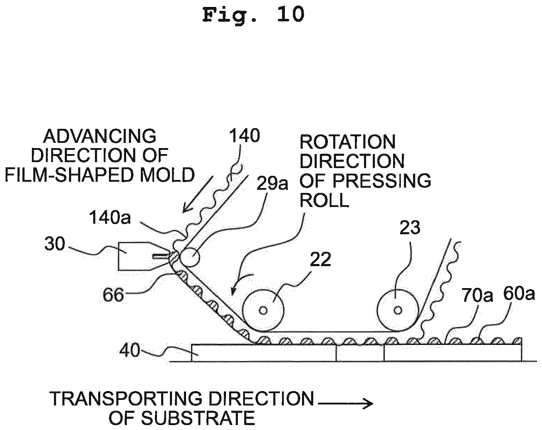

As depicted in Fig. 9(a), a concave-convex pattern of a mold 140 is coated with the solution of sol-gel material (inorganic material) prepared as described above, so as to form a coating film 66 in concavities 140a of the mold 140. When doing so, it is preferred that the solution of sol-gel material is filled (charged) only into the concavities 140a of the mold 140, while the solution of sol-gel material is not allowed to adhere to convexities 140b of the mold 140. Accordingly, a coating amount of the solution of sol-gel material is an amount equal to the volume of the concavities in the mold. As the mold 140, it is possible to use the mold for concave-convex pattern transfer. However, it is preferred to use a film-shaped mold having softness or flexibility. For example, as depicted in Fig. 10, the coating film 66 can be formed in concavities 140a of a film-shaped mold 140 by feeding the film-shaped mold 140 to a location in the vicinity of an end portion of a die coater 30, and by discharging the sol-gel material from the die coater 30. From the viewpoint of mass productivity, it is preferred that the film-shaped mold 140 is continuously transported (conveyed) while being continuously coated with the sol-gel material by the die coater 30 disposed at a predetermined position. As the coating method, it is possible to use any coating method including, for example, a bar coating method, a spray coating method, a die coating method, an ink-jet method, etc. In view of the fact that a mold having a relatively large width can be coated uniformly with the sol-gel material and that the coating can be completed quickly before the sol-gel material cures (forms a gel), the die coating method is preferred.

<Adhering step>

As depicted in Fig. 9(b), the mold 140 having the coating film 66 of the sol-gel material formed therein is pressed against the base member 40, thereby allowing the coating film 66 to adhere onto the base member 40. With this, the coating film 66 is adhered to portions, of the base member 40, each of which faces (is opposite to) one of the concavities 140a of the mold 40. In this situation, a pressing roll (adhering roll) may be used to press the mold 140 against the base member 40. It is allowable to use, as the base member 40, a base member of which surface is subjected to the hydrophilicity treatment with an $O_3$ treatment, etc. By performing the hydrophilicity treatment for the surface of the base member 40, it is possible to provide a great adhesion force between the base member 40 and the coating film 66 of the sol-gel material. As an example wherein the pressing roll is used to press the mold against the base member, for example, the film-shaped mold 140 having the coating film 66 formed therein is fed between a pressing roll 22 and the base member 40 which is being transported immediately below the pressing roll 22 as depicted in Fig. 10, thereby making it possible to adhere, to the base member 40, the coating film 66 formed in the concavities 140a of the film-shaped mold 140. Namely, when pressing the film-shaped mold 140, having the coating film 66 formed in the concavities 140a, against the base member 40 with the pressing roll 22, the surface of the base member 40 is covered with the film-shaped mold 140 while the film-shaped mold 140 and the base member 40 are transported in a synchronized manner. While doing so, by pressing the pressing roll 22 against the back surface of the film-shaped mold 140 (surface on the opposite side to the surface formed with the concave-convex pattern), the coating film 66 formed in the concavities 140a of the film-shaped mold 140 and the base member 40 are adhered to each other (brought into tight contact with each other) while advancing together. Note that in order to feed the long, film-shaped mold 140 toward the pressing roll 22, it is advantageous to feed and use the film-shaped mold 140 directly off from a film winding roll around which the long, film-shaped mold 140 is wound or rolled up.

In the adhering step, the coating film may be heated when the coating film is pressed against the base member. The heating of the coating film may be performed, for example, through or via the pressing roll, from the side of the base member, or the coating film may be heated directly. In a case that the coating film is heated through the pressing roll (adhering roll), a heating means may be provided in the pressing roll (adhering roll), and any heating means can be used. Although it is preferred that a heater be included in the pressing roll, the heater may be provided separately from the pressing roll. In any case, any pressing roll may be used, provided that the coating film can be pressed against (to) the base member while the coating film is being heated. Although any roll can be used as the pressing roll, the pressing roll is preferably a roll having a coating film, which is provided on a surface thereof and which is made of a heat-resistant resin material such as ethylene-propylene-diene rubber (EPDM), silicone rubber, nitrile rubber, fluoro rubber, acrylic rubber, chloroprene rubber, etc. Further, a supporting roll may be provided to face the pressing roll and to sandwich the base member between the supporting roll and the pressing roll, or a supporting stand configured to support the base member may be provided, for the purpose of resisting the pressure applied by the pressing roll.

The heating temperature of the coating film during the adhesion (pressing) may be in a range of the room temperature to 300°C. In a case that the heating is performed by using the pressing roll, the heating temperature of the pressing roll may be similarly in a range of the room temperature to 300°C. By heating the pressing roll as described above, it is possible to easily release (peel off) the mold from the coating film which has been pressed, thus making it possible to improve the productivity. In a case that the heating temperature of the coating film or the pressing roll exceeds 300°C, there is such a fear that the heating temperature might exceed the heat-resisting temperature of the mold made of the resin material. Further, by performing the pressing while heating the coating film, it is possible to expect the effect similar to that obtained by pre-baking of the sol-gel material layer, as will be described later on.

After the coating film is adhered to (brought into tight contact with) the base member, the coating film may be subjected to pre-baking. It is preferred to perform the pre-baking for the coating film in a case that the pressing is performed without heating the coating film. The pre-baking promotes gelation of the coating film to solidify the pattern, which in turn allows the pattern to be less likely to be collapsed during releasing or peeling of the mold. In a case that the pre-baking is performed, the heating is preferably performed at a temperature in a range of the room temperature to 300°C in the atmosphere. On the other hand, in a case that a material which generates an acid or alkali by being irradiated with light such as UV light is added to the sol-gel material solution, it is allowable, for example, to irradiate an energy ray represented by ultraviolet rays such as excimer UV light onto the coating film, instead of performing the pre-baking for the coating film.

<Releasing step>

The mold is released (peeled off) from the coating film and the base member after the adhering step. After the mold is released, as depicted in Fig. 9(c), the coating film of the sol-gel material is adhered to the portions, on the base member 40, corresponding to the concavities 140a of the mold 140 respectively, thereby forming convexities (convex portions) 60a on the base member 40. The surface of the base member 40 is exposed at areas thereof which are different from certain areas of the base member 40 corresponding respectively to the concavities 140a of the mold 140 (certain areas of the base member 40 at which the convexities 60a are formed respectively). In such a manner, the areas (concavities 70a) in which the surface of the base member 40 is exposed are defined between the concavities 60a formed of the sol-gel material. As the releasing (peeling) method for the mold, a publicly known releasing (peeling) method can be adopted. The mold may be released while being heated. By doing so, gas generated from the coating film is allowed to escape, thereby preventing the generation of bubbles in the film. In a case that the roll process is used, the releasing force may be smaller than that in a case of using a plate-shaped mold employed in the pressing system, and it is possible to easily release the mold from the coating film without allowing the coating film to be remained on the mold. In particular, since the pressing is performed while heating the coating film, the reaction easily proceeds, and the mold can be easily released from the coating film immediately after the pressing. Further, a releasing roll (peeling roll) may be used for enhancing the releasability (peelability) of the mold. As depicted in Fig. 10, a peeling roll (releasing roll) 23 is provided on the downstream of the pressing roll 22, and the film-shaped mold 140 and the coating film 66 are supported by the peeling roll 23, which is rotating, while being urged by the peeling roll 23 toward the base member 40. By doing so, it is possible to maintain a state that the film-shaped mold 140 and the coating film 66 are adhered to the base member 40 by a distance from the pressing roll 22 up to the peeling roll 23 (for a predetermined period of time corresponding to the above distance). Further, by changing the course of the film-shaped mold 140 such that the film-shaped mold 140 is lifted upward to a position above the peeling roll 23 at the downstream of the peeling roll 23, the film-shaped mold 140 is peeled off (released) from the convexities 60a formed of the coating film of the sol-gel material and the base member 40. Note that the pre-baking or the heating of the coating film described above may be performed during a period of time during which the film-shaped mold 140 is adhered to the base member 40. Further, in a case of using the peeling roll 23, the peeling off of the coating film from the film-shaped mold 140 can be performed more easily by performing the peeling while performing the heating, for example, at a temperature in a range of the room temperature to 300°C. Further, it is allowable to make the heating temperature of the releasing roll (peeling roll) 23 be higher than the heating temperature of the pressing roll and/or the pre-baking temperature. In such a case, by releasing the coating film while heating the coating film to a high temperature, it is possible to release any gas generated from the coating film 66 and thus to prevent air bubbles from being generated. Note that in Fig. 10, regarding a portion of the coating film 66 (coating film portion) which is not adhered to the base member 40, namely, a portion of the coating film 66 formed in a region, of the film-shaped mold 140, having a length corresponding to a distance (interval) between a certain base member 40 and another base member 40 transported after (subsequently to) the certain base member 40, is allowed to be transported together with the film-shaped mold 140 while being attached to (disposed on) the concavities 140a of the film-shaped mold 140.

<Curing Step>

After the mold is released, the convexities 60a formed of the sol-gel material are subjected to curing. The curing of the convexities 60a can be performed by a method similar to the method as described in the curing step of the concavity etching method. In such a manner, the convexities 60a are cured, thereby making it possible to form an epitaxial growth substrate 100a in which a concave-convex pattern 80a is composed of the convexities 60a and the concavities 70a which are formed on the base member 40. The surfaces of the convexities 60a may be subjected to the hydrophobic treatment, in a similar manner as in the concavity etching method as descried above.

As depicted in Fig. 9(e), it is allowable to etch the exposed portion in the surface of the epitaxial growth substrate 100a produced by the above-described method of the embodiment so as to form concavities (concave portions) 70b in the base member 40. With this, it is possible to form an epitaxial growth substrate 100b in which a concave-convex pattern 80b is composed of the convexities 60a and the concavities 70b. In the epitaxial growth substrate 100b, since the concavities 70b are formed in the base member 40, the depth of concavities and convexities of the concave-convex pattern can be made greater than the substrate 100a for which the etching is not performed for the base member 40.

In a case that a sapphire substrate is used as the base member, the etching of the base member can be performed, for example, by RIE using gas containing $BCl_3$, etc.

The concave-convex pattern of the mold 140 which is used in the peel transfer method has the cross-sectional shape which is formed of the relatively gently inclined surfaces and the planar shape in which convexities extend continuously in the ridge-like shape. Accordingly, similarly to the substrate etching method, the clogging of the mold is less likely to occur, which in turn makes it possible to reduce the frequency of cleaning (washing) or exchanging the mold. Therefore, in the peel transfer method, it is possible to realize a continuous production of the epitaxial growth substrate at a high speed and for a long period of time, and to suppress the production cost of the epitaxial growth substrate.

As compared with a method for producing the epitaxial growth substrate in which the surface of the base member is formed to have concavities and convexities to thereby form a concave-convex pattern, as in the substrate etching method, the method for producing the epitaxial growth substrate by the peel transfer method can shorten the time for producing the epitaxial growth substrate. In the adhering step of the method for producing the epitaxial growth substrate by the peel transfer method, the coating film of the sol-gel material is allowed to adhere only to the areas, of the base member, at which the convexities are to be ultimately formed, thereby allowing the surface of the base member to be exposed at portions, of the base member, which are different from the areas at which the convexities are formed, at a point of time after the mold has been released (peeled off). Therefore, in the peel transfer method, there is no need to perform any etching so that the surface of the base member is exposed. Accordingly, as compared with the case of forming the concavities and convexities by directly etching the surface of the base member to such an extent corresponding to the depth of concavities and convexities of the concave-convex pattern to be formed, the production time for producing the substrate can be shortened in the peel transfer method. Further, in a case that the surface of the base member is subjected to the etching, the surface of the base member exposed by the etching is roughened or made to be coarse (damaged) in some cases, which in turn necessitates any chemical liquid treatment, etc., after the etching. In the peel transfer method, however, there is no need to perform the etching. Thus, such a damage would not be generated, and there is no need to perform such a chemical liquid treatment.

Furthermore, since the roll process can be applied to the peel transfer method as described above, the epitaxial growth substrate can be produced continuously and at a high speed. Further, since the peel transfer method does not use the photolithography method, it is possible to reduce the production cost of the epitaxial growth substrate and to reduce the load to the environment.

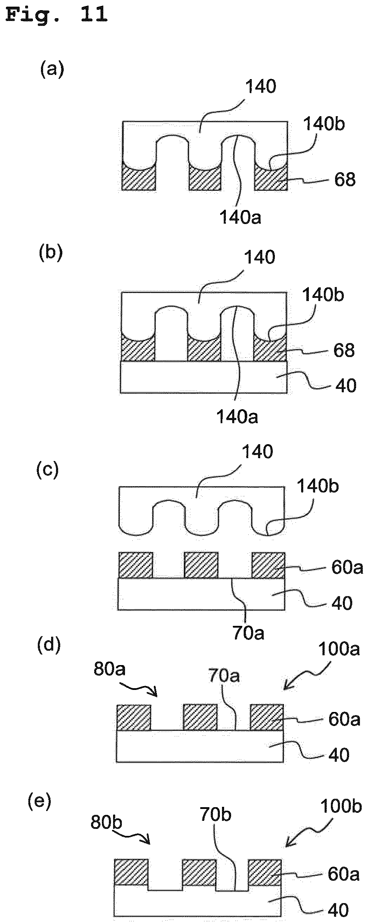

A modification of the peel transfer method will be explained with reference to Figs. 11(a) to 11(e), as follows. In the following, the modification of the peel transfer method is referred to as the "micro-contact method". Similarly to the peel transfer method, the micro-contact method mainly includes: a solution preparation step of preparing a sol-gel material; a coating step of coating a mold with the prepared sol-gel material (applying the prepared sol-gel material on the mold) to thereby form a coating film of the sol-gel material; an adhering step of adhering the sol-gel material, with which the mold is coated, to a base member; a releasing step (peeling step) of releasing (peeling off) the mold from the coating film; and a curing step of curing the coating film. In the peel transfer method, the convexities 60a formed on the base member 40 are formed in portions, of the base member 40, which face or are opposite to the concavities 140a of the mold 140; whereas in the micro-contact method, the convexities 60a are formed in portions, of the base member 40, which face or are opposite to the convexities 140b of the mold 140.

<Sol-gel material solution preparation step>

The preparation of a solution of a sol-gel material (sol) is performed in a same manner as the method explained regarding the peel contact method descried above.

<Coating step>

In the micro-contact method, as depicted in Fig. 11(a), only the convexities 140b of the mold 140 is coated with the prepared solution of sol-gel material (inorganic material) so as to form a coating film 68 on the convexities 140b of the mold 140. It is preferred that only the surfaces (the surfaces facing or opposite to the base member 40) of the convexities 140b of the mold 140 are coated with the solution of sol-gel material, there is such a possibility that, depending on the coating method, the sol-gel material might flow or move into a side portion(s) of a convexity 140b, namely finds its way up into a concavity 140a. Even in such a case, it is allowable that the sol-gel material adheres to the concavity (or concavities) 140a of the mold, provided that the convexities 60a formed of the sol-gel material in which the pattern of the convexities 140b of the mold 140 is reflected are formed on the base member 40 after the releasing step. As the coating method, it is possible to use any coating method including, for example, a bar coating method, a spin coating method, a spray coating method, a dip coating method, a die coating method, an ink-jet method, etc. In view of the fact that a mold having a relatively large area (size) can be coated uniformly with the sol-gel material and that the coating can be completed quickly before the sol-gel material cures (forms a gel), the bar coating method, the die coating method, and the spin coating method are preferred. Alternatively, it is allowable to form the mold to have a roll-shape, to immerse the roll-shaped mold into a sol-gel material shallowly filled in a container while rotating the roll-shaped mold, to thereby coat the convexities 140b of the mold with the sol-gel material. The roll-shaped mold can be manufactured, for example, by wounding a flexible mold around a hard roll made of, for example, a metal, etc. The coating film thickness (thickness) of the coating film 68 with which the convexities 140b of the mold is coated is preferably in a range of 1 nm to 3000 nm. The thickness of the coating film of the sol-gel material can be adjusted, for example, by adjusting, for example, the viscosity, etc. of the sol-gel material.

The mold used in the micro-contact method is preferably an elastically deformable mold such as the rubber mold described above. Further, it is preferred that, after the releasing step, the convexities are formed on the base member by transferring the coating film of the sol-gel material only to the portions of the base member respectively corresponding to the convexities of the mold. Accordingly, the average value of the depth distribution of the concavities and convexities in the mold is preferably a value in a range of 1 time to 10 times the average pitch of the concave-convex pattern to be formed. In a case that the average value of the depth distribution of concavities and convexities of the mold is smaller than the lower limit, a coating film of the sol-gel material is transferred also to a portion on the base member that is different from the intended portion(s) on the base member, in some cases. On the other hand, in a case that the average value of the depth distribution of concavities and convexities of the mold is greater than the upper limit, there is such a possibility that the shape of the mold might be deformed in an adhering step of the micro-contact method which will be described below, that the pattern of the convexities transferred onto the base member might collapse, and that any desired pattern might not be obtained.

<Adhering step>

As depicted in Fig. 11(b), the mold 140 having the coating film 68 of the sol-gel material formed thereon is pressed against the base member 40, thereby allowing the coating film 68 to adhere onto the base member 40. With this, the coating film 68 is adhered to portions, of the base member 40, facing or opposite to the convexities 140b, respectively, of the mold 40. It is allowable to use, as the base member 40, a base member of which surface is subjected to the hydrophilicity treatment with an $O_3$ treatment, etc. By performing the hydrophilicity treatment for the surface of the base member 40, it is possible to provide a greater adhesion force between the base member 40 and the coating film 68 of the sol-gel material.

It is allowable to heat the coating film of the sol-gel material, in the adhering step, when the base member is brought into contact with the coating film of the sol-gel material. By heating the coating film, the chemical reaction of the sol-gel material and the evaporation of the water generated by the chemical reaction and the solvent are promoted, thereby advancing the curing (gelation) of the coating film. This makes it possible to prevent an uncured coating film from spreading and wetting beyond or to be greater than the size of the convexity of the mold, and from being transferred onto the base member in such a state. Further, it is also possible to prevent the uncured coating film from remaining on the convexity of the mold after the releasing step. In a case that the coating film remains in the convexity of the mold, and that the mold is reused to produce another epitaxial growth substrate, there is such a fear that the thickness of the coating film formed on the mold might vary (fluctuate) and/or the remaining coating film might be hardened to cause any particle(s) to be generated. As a method for heating the coating film, for example, it is allowable to heat the coating film via the mold, or to heat the coating film directly or from the side of the base member. For the heating, any heating means can be used; for example, in a case of heating the coating film from the side of the base member, a hot plate can be disposed on the side of the back surface of the base member so as to heat the coating film. Although the heating temperature for heating the coating film depends on the speed at which the base member is processed, higher the temperature is, it is more preferred; a temperature which is close to the heatproof temperature of the mold is preferred. For example, in a case that the mold is formed of polydimethylsiloxane (PDMS), the heating temperature for the coating film of the sol-gel material is preferably in a range of 150°C to 200°C. In a case that a material generating an acid or alkali by being irradiated with a light such as ultraviolet ray is added to the solution of the sol-gel material, it is allowable for example to irradiate the energy ray represented by ultraviolet ray including the excimer UV light onto the coating film to thereby promote the gelation, rather than heating the coating film.

<Releasing step>

The mold is released from the coating film and the base member. After the mold is released, as depicted in Fig. 11(c), the coating film of the sol-gel material is adhered to portions, on the base member 40, corresponding to the convexities 140b of the mold 140 respectively, thereby forming convexities (convex portions) 60a on the base member 40. The surface of the base member 40 is exposed at areas thereof which are different from certain areas of the base member 40 corresponding respectively to the convexities 140b of the mold 140 (certain areas of the base member 40 at which the convexities 60a are formed respectively). In such a manner, the areas (concavities 70a) in which the surface of the base member 40 is exposed are defined between the concavities 60a formed of the sol-gel material. As the peeling method for the mold, a publicly known peeling method can be adopted. In a case that the above-described roll-shaped mold is used, it is possible to release the roll-shaped mold from the base member 40 by simply allowing the roll-shaped mold, which is coated with the sol-gel material, to roll on the base member 40, while transferring the coating film 68 of the sol-gel material onto the base member 40 and forming the convexities 60a in the base member 40.

<Curing step>

After the mold is released, the convexities 60a formed of the sol-gel material are subjected to curing. The curing can be performed with a method similar to that described regarding the curing step of the peel transfer method described above. In such a manner, the convexities 60a are cured, thereby making it possible to form an epitaxial growth substrate 100a wherein a concave-convex pattern 80a is composed of the convexities 60a and the concavities 70a which are formed on the base member 40, as depicted in Fig. 11(d). Further, it is allowable to perform hydrophobic treatment for the surfaces of the convexities 60a, in a similar manner in the peel transfer method as described above.

Note that similarly to the peel transfer method, it is allowable to etch the exposed portions in the surface of the epitaxial growth substrate 100 produced by the micro-contact method so as to form concavities (concave portions) 70b in the base member 40, as depicted in Fig. 11(e). With this, it is possible to form an epitaxial growth substrate 100b wherein a concave-convex pattern 80b is composed of the convexities 60a and the concavities 70b.

The concave-convex pattern of the mold 140 which is used in the micro-contact method has the cross-sectional shape which is formed of the relatively gently inclined surfaces and the planar shape in which convexities extend continuously in the ridge-like shape. Accordingly, similarly to the substrate etching method, the clogging of the mold is less likely to occur, which in turn makes it possible to reduce the frequency of cleaning (washing) or exchanging the mold. Therefore, in the micro-contact method, it is possible to realize a continuous production of the epitaxial growth substrate at a high speed and for a long period of time, and to suppress the production cost of the epitaxial growth substrate.

As compared with a method for producing the epitaxial growth substrate in which the surface of the base member is formed to have concavities and convexities to thereby form a concave-convex pattern, as in the substrate etching method, the method for producing the epitaxial growth substrate by the micro-contact method can shorten the time for producing the epitaxial growth substrate, similarly to the method for producing the epitaxial growth substrate by the peel transfer method. In the adhering step of the micro-contact method, the coating film of the sol-gel material is allowed to adhere only to the areas, of the base member, at which the convexities are to be ultimately formed, thereby allowing the surface of the base member to be exposed at portions, of the base member, which are different from the areas at which the convexities are formed, at a point of time after the mold has been released (peeled off). Therefore, in the micro-contact method, there is no need to perform any etching so that the surface of the base member is exposed. Accordingly, as compared with the case of forming the concavities and convexities by directly etching the surface of the base member to such an extent corresponding to the depth of concavities and convexities of the concave-convex pattern to be formed, the production time for producing the epitaxial growth substrate can be shortened in the peel transfer method. Further, in a case that the surface of the base member is subjected to the etching, the surface of the base member exposed by the etching is roughened or made to be coarse (damaged) in some cases, which in turn necessitates any chemical liquid treatment, etc., after the etching. In the micro-contact method, however, there is no need to perform the etching. Thus, such a damage would not be generated, and there is no need to perform such a chemical liquid treatment.

Furthermore, similarly to the peel transfer method, since the roll process can be applied also to the micro-contact method, the epitaxial growth substrate can be produced continuously and at a high speed. Further, since the micro-contact method does not use the photolithography method, it is possible to reduce production cost of the epitaxial growth substrate, and to reduce the load to the environment.

A buffer layer may be further formed, on a surface (surface having the concave-convex pattern formed therein) of each of the epitaxial growth substrates produced by the substrate etching method, the concavity etching method, the peel transfer method and the micro-contact method, respectively, and a substrate obtained thereby is also encompassed by the epitaxial growth substrate of the embodiment. As exemplified by those depicted in Figs. 3(a) to 3(c), such a substrate is provided with a buffer layer 20 on a surface of the concave-convex pattern 80, 80a or 80b. Further, since the concave-convex pattern has the cross-sectional shape which is formed of relatively gently inclined surfaces and constructs the waveform structure, it is possible to form a buffer layer with little defect.

It is also allowable to form the buffer layer on the base member before the coating step in the substrate etching method, or before the adhering step in the peel transfer method and the micro-contact method, and a substrate obtained thereby is also encompassed by the epitaxial growth substrate of the embodiment. As exemplified by that depicted in Fig. 3(d), convexities 60a are formed to project from a surface of the buffer layer 20 and areas at which a surface of the buffer layer 20 is exposed (concavities 70f) are defined between the convexities 60a, thereby forming a concave-convex pattern 80f.

The buffer layer 20 can be formed by using a publicly known method such as a low-temperature MOCVD (metal-organic chemical vapor deposition) method, sputtering method, etc.; and the layer thickness (thickness) of the buffer layer 20 is preferably in a range of 1 nm to 100 nm. In a case of allowing a semiconductor layer to be epitaxially grown on the surface of each of the epitaxial growth substrates 100c, 100d, 100e and 100f having the buffer layer, the buffer layer accommodates or decreases any lattice mismatch (difference in the lattice constant) between the base member and the semiconductor layer, thereby making it possible to form a semiconductor layer having a high crystallinity. In a case of allowing a GaN-based semiconductor layer to be epitaxially grown on the epitaxial growth substrate 100c, 100d, 100e or 100f, the buffer layer can be composed of $Al_xGa_{1-x}N$ ($0 \leq x \leq 1$); and the buffer layer is not limited to a single layer structure, but may be a multi-layer structure formed of two or more layers in which two or more kinds of layers having different compositions are stacked.

Note that in the concavity etching method, the micro-contact method and the peel transfer method, a solution of the sol-gel material such as $TiO_2$, ZnO, ZnS, ZrO, $BaTiO_3$, $SrTiO_2$, etc., or a dispersion liquid of fine particles may be used as the solution of the inorganic material with which the coating is performed in the coating step. Among the above materials, $TiO_2$ is preferably used in view of the film formation performance (coating property) and the refractive index. The coating film made of inorganic material may be formed by a liquid phase deposition (LPD) and the like.

Alternatively, a polysilazane solution may be used as the solution of the inorganic material with which the coating is performed in the coating step. In this case, it is also allowable to obtain convexities by performing application and transfer using the polysilazane solution, and to ceramicize (perform silica reforming or modification for) the formed convexities in the curing step to thereby form convexities made of silica. Note that the "polysilazane" is a polymer having a silicon-nitrogen bond, is an inorganic polymer comprising Si-N, Si-H, N-H, or the like, and is a precursor of a ceramics such as $SiO_2$, $Si_3N_4$, or $SiO_xN_y$, which is an intermediate solid solution of such a ceramics. A compound, which is ceramized at relatively low temperature and is modified into silica, as that represented by the following formula (1) described in Japanese Patent Application Laid-open No. H08-112879, is more preferable.

Formula (1):          -Si (R1) (R2)-N (R3)-

In the formula (1), R1, R2, and R3 each represent a hydrogen atom, an alkyl group, an alkenyl group, a cycloalkyl group, an aryl group, an alkylsilyl group, an alkylamino group, or an alkoxy group.

Among the compounds represented by the formula (1), perhydropolysilazane (referred to also as PHPS) in which all of R1, R2, and R3 are hydrogen atoms and organopolysilazane in which a part of the hydrogen bonded to Si thereof is substituted by, for example, an alkyl group are particularly preferred.

Other examples of the polysilazane ceramized at low temperature which are usable include: silicon alkoxide-added polysilazane obtained by reacting polysilazane with silicon alkoxide (see, for example, Japanese Patent Laid-Open No. H05-238827); glycidol-added polysilazane obtained by reaction with glycidol (see, for example, Japanese Patent Laid-open No. H06-122852); alcohol-added polysilazane obtained by reaction with alcohol (see, for example, Japanese Patent Laid-open No. H06-240208); metal carboxylate-added polysilazane obtained by reaction with metal carboxylate (see, for example, Japanese Patent Laid-Open No. H06-299118); acetylacetonato complex-added polysilazane obtained by reaction with an acetylacetonato complex containing a metal (see, for example, Japanese Patent Laid-Open No. H06-306329); metallic fine particles-added polysilazane obtained by adding metallic fine particles (see, for example, Japanese Patent Laid-Open No. H07-196986), and the like.

As the solvent of the polysilazane solution, it is possible to use hydrocarbon solvents such as aliphatic hydrocarbons, alicyclic hydrocarbons, and aromatic hydrocarbons; halogenated hydrocarbon solvents; and ethers such as aliphatic ethers and alicyclic ethers. Amine or a metal catalyst may be added in order to promote the modification into a silicon oxide compound.

[Light-emitting element]

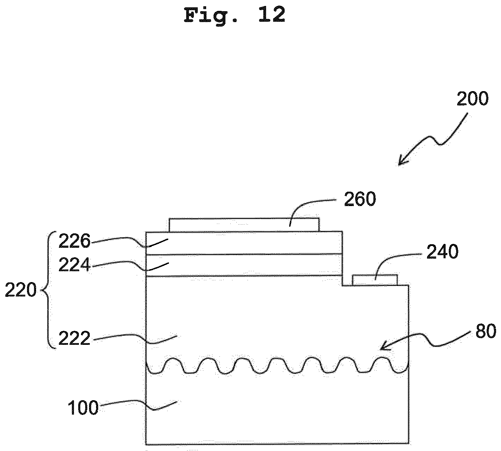

A light-emitting element can be produced by using the epitaxial growth substrate of the embodiments. As depicted in Fig. 12, a light-emitting element 200 of the embodiment is provided with a semiconductor layer 220 formed by stacking a first conductivity type layer 222, an active layer 224, a second conductivity type layer 226 on the epitaxial growth substrate 100, in this order. Further, the light-emitting element 200 of the embodiment is provided with a first electrode 240 electrically connected to the first conductivity type layer 222 and a second electrode 260 electrically connected to the second conductivity type layer 226.

As the material for the semiconductor layer 220, a publicly known material usable for light-emitting element may be used. As the material usable for light-emitting element, for example, a large number of GaN-based semiconductor materials represented by a general formula: $In_xAl_yGa_{1-x-y}N$ ($0 \leq x \leq 1$, $0 \leq y \leq 1$, $0 \leq x+y \leq 1$) are known; also in the light-emitting element of the embodiment, a GaN-based semiconductor material represented by a general formula: $Al_XGa_YIn_ZN_{1-A}M_A$, including these publicly known GaN-based semiconductor materials, can be used without any limitation. The GaN-based semiconductor may contain, in addition to Al, Ga and In, another group III element(s), and may also contain elements such as Ge, Si, Mg, Ca, Zn, Be, P, As, B, etc., as necessary. Further, the GaN-based semiconductor contains not only the intentionally added element(s), but also any impurity inevitably contained depending on the growth condition of the semiconductor layer, etc., and trace impurity or impurities contained in the raw material and/or in the reaction tube material, in some cases. Other than the above-described nitride semiconductor, it is possible to use also other semiconductor materials such as GaAs, GaP-based semiconductors, AlGaAs, InAlGaP-based semiconductors, etc.

A n-type semiconductor layer 222 as the first conductivity type layer is stacked on the substrate 100. The n-type semiconductor layer 222 may be formed of a publicly known material in the art and may have a publicly known structure in the art, and may be, for example, formed of n-GaN. The active layer 224 is stacked on the n-type semiconductor layer 222. The active layer 224 may be formed of a publicly known material and may have a publicly known structure, and may have, for example, a multiple quantum well (MQW) structure in which GaInN and GaN are stacked a plurality of times. The active layer 224 emits light by the injection of holes and electrons. A p-type semiconductor layer 226 as the second conductivity type layer is stacked on the active layer 224. The p-type semiconductor layer 226 may have a publicly known structure in the art, and may be, for example, formed of p-AlGaN and p-GaN. The method of stacking the semiconductor layer (n-type semiconductor layer, active layer and p-type semiconductor layer) is not particularly limited, and a publicly known method capable of growing the GaN-based semiconductor, such as MOCVD (metal-organic chemical vapor deposition) method, HVPE (hydride vapor growth) method, MBE (molecular-beam epitaxy) method, etc., can be applied. The MOCVD method is preferred in view of the layer-thickness controllability, mass productivity, etc.

Although the concave-convex pattern 80 is formed in the surface of the epitaxial growth substrate 100, the flattening (planarization) of surface of semiconductor layer due to the growth of semiconductor layer in the lateral direction, as described in Japanese Patent Application Laid-open No. 2001-210598, proceeds while the n-type semiconductor layer is being epitaxially growing. Since the active layer needs to be formed on a flat surface, the n-type semiconductor layer needs to be stacked until a surface thereof is flattened. In the epitaxial growth substrate of the embodiment, since the cross-sectional shape of the concave-convex pattern is formed of relatively gently inclined surfaces and constructs a waveform structure, the flattening of the surface proceeds quickly and the thickness of the n-type semiconductor layer can be made small, thereby making it possible to shorten the growth time of the semiconductor layer.

A n-electrode 240 as the first electrode is stacked on the n-type semiconductor layer 222 at a portion or area thereof which is exposed by etching away a portion of each of the p-type semiconductor layer 226 and the active layer 224. The n-electrode 240 may be formed of a publicly known material in the art and may have a publicly known structure in the art, and is composed, for example, of Ti/Al/Ti/Au, etc., and is formed, for example, by the vacuum vapor deposition method, sputtering method, CVD method, etc. A p-electrode 260 as the second electrode is formed on the p-type semiconductor layer 226. The p-electrode 260 may be formed of a publicly known material in the art and may have a publicly known structure in the art, and may be, for example, formed of a light-transmitting (translucent) conductive film formed of ITO, etc., and an electrode pad constructed of a Ti/Au stacked body, and the like. The p-electrode 260 may be formed of a high-reflex material such as Ag, Al, etc. The n-electrode 240 and the p-electrode 260 can be formed by an arbitrary film-forming method such as the vacuum vapor deposition method, sputtering method, CVD method, etc.

Note that the layer structure of the semiconductor layer may take any structure, provided that the layer structure includes at least the first conductivity type layer, the active layer and the second conductivity type layer, and that when voltage is applied between the first and second conductivity type layers, the hole and electron are recombined to thereby generate light emission or radiation in the active layer.

The light-emitting element 200 of the embodiment constructed as described above may be an optical element of the face-up system in which the light is extracted from the side of the p-type semiconductor layer 226; in such a case, it is preferred that a

light-transmitting conductive material is used for the p-electrode 260. The light-emitting element 200 of the embodiment may be an optical element of the flip-chip system in which the light is extracted from the side of the substrate 100; in such a case, it is preferred that a high-reflex material is used for the p-electrode 260. In either one of these systems, it is possible to effectively extract the light generated in the active layer 224 to the outside of the element, by the diffraction effect brought about by the concave-convex pattern 80 of the substrate.

Further, in the optical element 200, since the concave-convex pattern 80 is formed in the substrate 100, the semiconductor layer 220 in which the dislocation density is small is formed, thereby suppressing any degradation in the characteristic of the light-emitting element 200.

EXAMPLES

In the following description, the present invention will be specifically explained with examples and comparative examples. The present invention, however, is not limited to the following examples and comparative examples.

[Example 1]

<Manufacture of Film-shaped Mold>

At first, there was prepared a block copolymer produced by POLYMER SOURCE INC., which was made of polystyrene (hereinafter referred to as "PS" in an abbreviated manner as appropriate) and polymethyl methacrylate (hereinafter referred to as "PMMA" in an abbreviated manner as appropriate) as described below.

Mn of PS segment= 800,000
Mn of PMMA segment= 750,000
Mn of block copolymer = 1,550,000
Molecular weight distribution (Mw/Mn)= 1.28

Toluene was added to 150 mg of the block copolymer and 45 mg of Polyethylene Glycol 2050 manufactured by ALDRICH (average Mw = 2050) as polyethylene oxide so that the total amount thereof was 10 g, and the block copolymer and the polyethylene oxide were dissolved. This solution was filtered through a membrane filter having a pore diameter of 0.2 $\mu$m, and thus a block copolymer solution was obtained.

A glass substrate was coated with a mixed solution containing 1 g of KBM-5103 manufactured by SHIN-ETSU SILICONE (SHIN-ETSU CHEMICAL, CO., LTD.), 1 g of ion-exchanged water, 0.1 ml of acetic acid and 19 g of isopropyl alcohol, by the spin coating (which was performed for 30 seconds with rotation speed of 1000 rpm). Then, the substrate coated with the mixed solution was heated for 15 minutes at 130 °C, and thus a silane-coupling treated glass was obtained. The silane-coupling treated glass was used as the base member, and the base member was coated with the obtained block copolymer solution by the spin coat, and thus a thin film of the block copolymer having a film thickness of 160 nm was formed on the base member. The spin coat was performed for 30 seconds with a rotation speed of 1000 rpm.

Then, the base member on which the thin film was formed was subjected to the solvent annealing process by being stationarily placed in a desiccator, filled in advance with chloroform vapor, at a room temperature for 35 hours. Inside the desiccator (volume: 5 L), a screw-type container charged with 15 g of chloroform was placed, and the atmosphere inside the desiccator was filled with chloroform at the saturated vapor pressure. Concavities and convexities were observed on the surface of the thin film after the solvent annealing process, and it was found that the block copolymer composing the thin film underwent the micro phase separation.

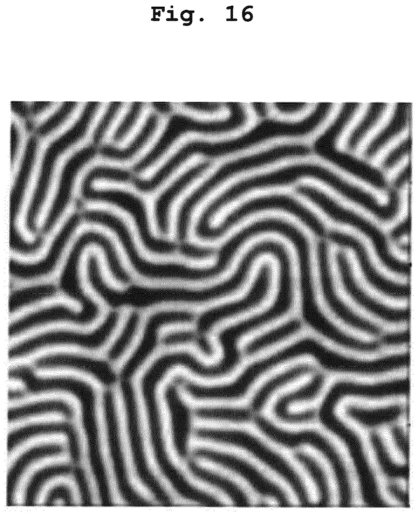

The concave-convex shape of the surface of the thin film subjected to the solvent annealing process and imparted with the waveform shape (waveform structure) (in a step before electroplating) was observed by an atomic force microscope (a scanning probe microscope equipped with an environment control unit "Nanonavi II Station/E-sweep" manufactured by SII NANOTECHNOLOGIES), and thus an analysis image was obtained. The obtained analysis image is depicted in Fig. 16. Analysis conditions of the atomic force microscope were as follows.

Measurement mode: dynamic force mode
Cantilever: SI-DF40P2 (material: Si, lever width: 40 $\mu$m, diameter of tip of chip: 10 nm)
Measurement atmosphere: in air
Measurement temperature: 25°C

A thin nickel layer of about 50 nm was formed as a current seed layer by sputtering on the surface, of the thin film, which was imparted with the waveform shape by the solvent annealing process as described above. Subsequently, the base member with the thin film was subjected to an electroforming process (maximum current density: 0.05A/cm$^2$) in a nickel sulfamate bath at a temperature of 50°C to precipitate nickel until the thickness of nickel became 250 $\mu$m. The base member with the thin film was mechanically peeled off from the nickel electroforming body obtained as described above.

Subsequently, the nickel electroforming body was immersed in HD-2101TH manufactured by DAIKIN CHEMICAL SALES, CO., LTD. for about 1 minute and was dried, and then stationarily placed overnight. The next day, the nickel electroforming body was immersed in HDTH manufactured by DAIKIN CHEMICAL SALES, CO., LTD. and was subjected to an ultrasonic cleaning process for about 1 minute. In such a manner, a nickel mold for which a mold-release treatment had been performed was obtained.

Subsequently, a PET substrate (Cosmoshine A-4100 manufactured by TOYOBO CO., LTD.) was coated with a fluorine-based UV curable resin. Then, the fluorine-based UV curable resin was cured by being irradiated with ultraviolet light at 600 mJ/cm$^2$ while the nickel mold was pressed to the PET substrate. After curing of the resin, the nickel mold was peeled off or released from the cured resin. In such a manner, a film mold made of the PET substrate with the resin film to which the surface profile (surface shape) of the nickel mold was transferred was obtained. The surface of the film mold was measured by the atomic force microscope, and it was found out that the concave-convex pattern formed on the surface of the film mold had a plurality of convexities of which extending directions, bending directions and lengths are non-uniform among the convexities, and that each of the convexities had an elongated shape extending while winding. The average pitch of the concavities and convexities of the concave-convex pattern was 600 nm, and the average value of the depth distribution of the concavities and convexities was 85 nm.

<Manufacture of Epitaxial Growth Substrate>

A single crystal sapphire substrate (manufactured by KYOCERA CORPORATION) of which main plane was C-plane was cleaned or washed by a general cleaning (washing) method. Subsequently, Ni was deposited on the sapphire substrate by the sputtering, and a Ni-layer (mask layer) having a film thickness of 50 nm was formed on the sapphire layer. Further, the mask layer was coated with a thermoplastic resin, as a resist, by the spin coating. The film thickness of the formed resist film was 120 nm. The sapphire substrate formed with the mask layer and the resist film was heated to a temperature of 150°C so as to soften the resist film, and then the film mold was pressed against the resist film. In a state that the film mold was remained to be pressed against the resist film, the sapphire substrate was cooled down to the room temperature. Afterwards, the film mold was released (peeled off) from the resist film. By doing so, the concave-convex pattern of the surface of the film mold was transferred to the resist film. In this process, the resist film remained in the concavities of the transferred concave-convex pattern. Namely, at the concavities of the concave-convex pattern, the mask layer was not exposed to the surface.

The sapphire substrate formed with the resist film having the concave-convex pattern was subjected to a plasma ashing process using an $O_2$ gas. With this, the resist film remained in the convexities of the concave-convex pattern, whereas the mask layer was exposed at the concavities of the concave-convex pattern.

Next, a plasma etching process using an Ar gas was performed for the sapphire substrate. With this, the mask layer exposed at the concavities of the concave-convex pattern was etched, thereby exposing the sapphire substrate at the etched-away portions of the mask layer. Further, a plasma etching process using a $BCl_3$ gas was performed for the sapphire substrate. With this, the sapphire substrate was etched at the portions exposed at the concavities of the concave-convex pattern. Afterwards, the sapphire substrate subjected to the etching process was immersed in heated nitric acid. With this, the mask layer and the resist film remained on the substrate was removed.

By the above-described processing, the concave-convex pattern of the film mold was transferred to the sapphire substrate. In the embodiment, the sapphire substrate to which the concave-convex pattern was transferred was used as the epitaxial growth substrate. The surface of the epitaxial growth substrate was measured by the atomic force microscope, and thus a concavity and convexity analysis image was obtained. From the obtained analysis image, it was found out that the concave-convex pattern formed in the surface of the epitaxial growth substrate had a plurality of convexities of which extending directions, bending directions and lengths are non-uniform among the convexities; and each of the convexities had an elongated shape which extended while winding (waving) in a plane view. Further, it was found out that the cross-sectional shape of the concave-convex pattern was formed of gently inclined surfaces and constructed a waveform structure. The average pitch of the concavities and convexities of the concave-convex pattern was 600 nm, the average value of the depth distribution of the concavities and convexities was 130 nm, and the standard deviation of the depths of convexities and concavities was 87.0 nm. Furthermore, a Fourier-transformed image obtained by performing the two-dimensional fast Fourier-transform processing on the concavity and convexity analysis image showed a annular pattern substantially centered at an origin at which an absolute value of wavenumber is 0 $\mu m^{-1}$.

<Manufacture of Light-emitting element>

AlN was deposited on the epitaxial growth substrate by the sputtering method. Subsequently, a semiconductor layer based on a gallium nitride compound was stacked on the AlN layer. The semiconductor layer based on the gallium nitride compound had a structure in which a base layer, an n-type semiconductor layer, a light-emitting layer (active layer) and a p-type semiconductor layer were stacked in this order. The base layer was composed of an undoped GaN layer having a thickness of 3 $\mu m$. The n-type semiconductor layer was composed of an n-type GaN layer doped with silicon and having a thickness of 3 $\mu m$. The light-emitting layer was formed to have a multiple quantum well (MQW) structure in which GaInN/GaN were formed in five cycles. The p-type semiconductor layer was composed of a p-type GaN doped with Mg. The stacking of the semiconductor layer based on the gallium nitride compound was performed by the MOCVD method under general conditions well-known in the art.

A region, of the GaN layer, at which an n-electrode was to be formed, was exposed by the ICP etching method. The n-electrode was formed on the n-type GaN layer, and a p-electrode was formed on the p-type GaN layer. The exposure of the n-type GaN layer and the formations of the n-electrode and the p-electrode were performed by general photolithography method, etching method, sputtering method and vapor deposition method and with general etching gas and material for electrodes.

After forming the n-electrode and the p-electrode, the back surface of the sapphire substrate was ground and polished. Next, a laser scriber was used to draw marking lines from the side of the semiconductor layer, and then sapphire substrate was press-cut into chips each having a size of vertical: 1 mm x horizontal: 0.5 mm. With this, light-emitting elements were obtained.

[Comparative Example 1]

A light-emitting element was manufactured in a similar manner as in Example 1, except that a sapphire substrate having a concave-convex pattern formed therein by the electron beam lithography method was used as the epitaxial growth substrate, rather than using the sapphire substrate to which the concave-convex pattern of the film mold was transferred. In Comparative Example 1, the epitaxial growth substrate had a concave-convex pattern in which circular-cone shaped projections (convexities) of which diameter of base was 2.7 $\mu$m and of which height was 1.6 $\mu$m were arranged in a shape of a triangular lattice at a frequency of 3 $\mu$m. A Fourier-transformed image obtained by performing the two-dimensional fast Fourier-transform processing on a concavity and convexity analysis image obtained by measuring the surface of the epitaxial growth substrate with the atomic force microscope showed a point-shaped image in which bright spots gathered at apexes of a hexagon substantially centered at an origin at which an absolute value of wavenumber is 0 $\mu$m$^{-1}$.

[Comparative Example 2]

A light-emitting element was manufactured in a similar manner as in Example 1, except that a sapphire substrate not formed with any concave-convex pattern was used as the epitaxial growth substrate, rather than using the sapphire substrate to which the concave-convex pattern of the film mold was transferred.

<Measurement of Rocking Curve>

After forming the base layer (undoped GaN) in each of Example 1 and Comparative Example 1, an X-ray diffraction apparatus was used to measure a rocking curve of GaN (0002) plane. The half-value width of the rocking curve of the base layer of Example 1 was 260 arcsec. The half-value width of the rocking curve of the base layer of Comparative Example 1 was 284 arcsec. From these results, it was found out that the tilt distribution of the crystal in the base layer of Example 1 was smaller than that of the base layer of Comparative Example 1, and thus had an excellent crystallinity.

<Observation by Differential Interference Microscope>

After forming the base layer (undoped GaN) in each of Example 1 and Comparative Example 1, the surface of the base layer was observed by using a differential interference microscope; and it was found out that the surface of the base layer of Example 1 was flatter than the surface of the base layer of Comparative Example 1.
From the results of the measurement of the rocking curve and the observation by the differential interference microscope, it was considered that Example 1 was formed with a semiconductor layer which had less defect and was more excellent in the crystallinity than that of Comparative Example 1. In Example 1, since the cross-sectional shape of the concave-convex pattern of the epitaxial growth substrate was formed of the relatively gently inclined surfaces as described above, the semiconductor layer was stacked uniformly on the concave-convex pattern, which in turn made it possible to epitaxially grow the semiconductor layer satisfactorily.

<Evaluation of Light-extraction Efficiency of Light-Emitting Element>

Voltage (V) was applied to each of the light-emitting elements of Example 1 and Comparative Example 2 by using a voltage application measuring instrument (mode name: R6244, manufactured by ADVANTEST CORPORATION), and a current (I) flowing through the light-emitting element was measured. Further, a total light-flux measuring apparatus (model name: Solid Lambda CCD UV-NIR, manufactured by SPECTRA CO-OP.) was used to apply the voltage (V) to the produced light-emitting element of each of Example 1 and Comparative Example 2, and the total light flux (L) was measured. The measured value was fitted to the following formula (I), and the light extraction efficiency was obtained. Formula (I):

$$EQE = IQE \times EIE \times LEE ... (I)$$

In the formula (I), "EQE" indicates the external quantum efficiency, "IQE" indicates the internal quantum efficiency, "EIE" indicates the electron injection efficiency, and "LEE" indicates the light extraction efficiency. Note that the EIE is 100%. The IQE was calculated by the method described in YOSHIDA et al, "APPLIED PHYSICS LETTERS", 96, 211122 (2010).

The light extraction efficiency of the light-emitting element of Example 1 was 17.8%. The light extraction efficiency of the light-emitting element of Comparative Example 2 was 10.0%. Namely, the light extraction efficiency of Example 1 was higher than that of Comparative Example 2. From this result, it was found out that the sapphire substrate used in Example 1 as the epitaxial growth substrate had the function as a diffraction grating substrate which improves the light extraction efficiency.

Although the present invention has been explained as above with the embodiments, the optical element of the present invention is not limited to the above-described embodiments, and may be appropriately modified or changed within the range of the technical ideas described in the following claims.

INDUSTRIAL APPLICABILITY

The concave-convex pattern of the epitaxial growth substrate of the present invention can be produced efficiently by the imprinting method. Further, it is possible to produce an epitaxial layer having fewer defects by using the epitaxial growth substrate. Furthermore, the epitaxial growth substrate of the present invention has the function as a diffraction grating substrate capable of improving the light extraction efficiency, thereby allowing a light-emitting element produced by using this epitaxial growth substrate to have a high light emission efficiency. Therefore, the epitaxial growth substrate of the present invention is quite effective for producing a light-emitting element having an excellent light emission efficiency, and also contributes to the energy conservation.

Reference Sign List:

| 20 | buffer layer |
| 40 | base member |
| 60 | convexity |
| 70 | concavity |
| 80 | concave-convex pattern |
| 100 | epitaxial growth substrate |
| 120 | resist layer |
| 140 | mold |
| 200 | light-emitting element |
| 220 | semiconductor layer |

**Claims**

1. An epitaxial growth substrate comprising a base member, and a concave-convex pattern having a plurality of concavities and a plurality of convexities and formed on the base member, wherein:

    (i) each of the plurality of convexities has an elongated shape which extends while winding in a plane view; and
    (ii) the plurality of convexities in the concave-convex pattern have extending directions, bending directions and lengths which are non-uniform among the plurality of convexities.

2. The epitaxial growth substrate according to claim 1, wherein an average pitch of the plurality of concavities and the plurality of convexities in the concave-convex pattern is in a range of 100 nm to 10 μm.

3. The epitaxial growth substrate according to claim 1 or 2, wherein the plurality of convexities have a cross-sectional shape, in a direction orthogonal to the extending directions of the plurality of convexities, which is narrowing from a bottom portion, of each of the plurality of convexities, toward an apex portion of each of the plurality of convexities.

4. The epitaxial growth substrate according to any one of claims 1 to 3, wherein a part of the plurality of convexities has a branched shape.

5. The epitaxial growth substrate according to any one of claims 1 to 4, wherein a concave-convex cross-sectional shape appears repeatedly under a condition that the concave-convex pattern is cut in any plane orthogonal to a surface of the base member.

6. The epitaxial growth substrate according to any one of claims 1 to 5, wherein standard deviation of depths of the plurality of convexities and the plurality of concavities in the concave-convex pattern is in a range of 10 nm to 5 $\mu$m.

7. The epitaxial growth substrate according to any one of claims 1 to 6, wherein the extending directions of the plurality of convexities are distributed irregularly in the plane view; and
a contour in the plane view of convexities, among the plurality of convexities, included in a region of unit area of the concave-convex pattern contains a straight line section in an amount greater than that of a curved line section.

8. The epitaxial growth substrate according to claim 7, wherein widths of the convexities in a direction substantially orthogonal in the plane view to the extending directions of the convexities are constant.

9. The epitaxial growth substrate according to claim 7 or 8, wherein under a condition that a plurality of sections are formed in the contour in the plane view of the convexities by segmenting the contour by a length which is $\pi$ (circumference ratio) times an average value of widths of the convexities, the curved line section is a section, among the plurality of sections, in which ratio of a linear distance between both end points in the section to length, in the contour, between the both end points in the section is not more than 0.75, and the straight line section is a section which is not the curved line section among the plurality of sections.

10. The epitaxial growth substrate according to claim 7 or 8, wherein under a condition that a plurality of sections are formed in the contour in the plane view of the convexities by segmenting the contour by a length which is $\pi$ (circumference ratio) times an average value of widths of the convexities, the curved line section is a section, among the plurality of sections, in which an angle is not more than 120 degrees, the angle being one angle of not more than 180 degrees among two angles defined by a line segment connecting one end point of the section to a middle point of the section and another line segment connecting the other end point of the section to the middle point of the section, and the straight line section is a section which is not the curved line section among the plurality of sections; and ratio of the curved line section in the plurality of sections is not less than 70%.

11. The epitaxial growth substrate according to any one of claims 1 to 6, wherein the extending directions of the plurality of convexities are distributed irregularly in the plane view; and
widths of the plurality of convexities in a direction substantially orthogonal in the plane view to the extending directions of the plurality of convexities are constant.

12. The epitaxial growth substrate according to any one of claims 1 to 11, wherein a Fourier-transformed image, obtained by performing a two-dimensional fast Fourier-transform processing on a concavity and convexity analysis image obtained by analyzing the concave-convex pattern with a scanning probe microscope, shows a circular or annular pattern substantially centered at an origin at which an absolute value of wavenumber is 0 $\mu$m$^{-1}$; and
the circular or annular pattern is present within a region in which the absolute value of wavenumber is in a range of not more than 10 $\mu$m$^{-1}$.

13. The epitaxial growth substrate according to any one of claims 1 to 12, further comprising a buffer layer which is formed on a surface, of the base member, having the concave-convex pattern formed therein.

14. The epitaxial growth substrate according to any one of claims 1 to 13, wherein the plurality of convexities are formed of a material different from a material constructing the base member.

15. The epitaxial growth substrate according to claim 14, wherein the plurality of convexities are formed of a sol-gel material.

16. The epitaxial growth substrate according to any one of claims 1 to 13, wherein the plurality of concavities are formed of a material same as a material constructing the base member.

17. The epitaxial growth substrate according to any one of claims 1 to 16, wherein the base member is a sapphire substrate.

18. A light-emitting element comprising a semiconductor layer which is provided on the epitaxial growth substrate as defined in any one of claims 1 to 17, and which includes at least: a first conductivity type layer, an active layer and a second conductivity type layer.

**Fig. 1**

(a)

(b)

(c)

Fig. 2

(a)

(b)

# Fig. 3

(a)

(b)

(c)

(d)

# Fig. 4

(a)

120
40

(b)

140
120
40

(c)

120
40

(d)

60
80
40
70

## Fig. 5

```
┌──────────────┐
│ PREPARATION  │⌒ S1
│ OF SOLUTION  │
└──────┬───────┘
       ↓
┌──────────────┐
│   COATING    │⌒ S2
└──────┬───────┘
       ↓
┌──────────────┐
│   DRYING     │⌒ S3
└──────┬───────┘
       ↓
┌──────────────┐
│   PRESSING   │⌒ S4
└──────┬───────┘
       ↓
┌──────────────┐
│  PRE-BAKING  │⌒ S5
└──────┬───────┘
       ↓
┌──────────────┐
│  RELEASING   │⌒ S6
└──────┬───────┘
       ↓
┌──────────────┐
│   ETCHING    │⌒ S7
└──────┬───────┘
       ↓
┌──────────────┐
│   CURING     │⌒ S8
└──────────────┘
```

# Fig. 6

(a)

64
40

(b)

140
64
40

(c)

140
62
40

(d)

70a
80a
60a
100a
62a
40

(e)

70b
80b
60b
100b
60a
62a
40

Fig. 7

ADVANCING
DIRECTION OF
FILM-SHAPED MOLD

ROTATION
DIRECTION
OF PRESSING
ROLL

123

122

140

62

64

40

TRANSPORTING $\longrightarrow$
DIRECTION OF SUBSTRATE

Fig. 8

```
┌─────────────────┐
│   PREPARATION   │ ～ P1
│   OF SOLUTION   │
└─────────────────┘
         │
         ▼
┌─────────────────┐
│     COATING     │ ～ P2
└─────────────────┘
         │
         ▼
┌─────────────────┐
│    ADHERING     │ ～ P3
└─────────────────┘
         │
         ▼
┌─────────────────┐
│    RELEASING    │ ～ P4
└─────────────────┘
         │
         ▼
┌─────────────────┐
│     CURING      │ ～ P5
└─────────────────┘
```

Fig. 9

(a)

140

66

140a

(b)

140b    140a    140

66

40

(c)

140b    140a    140

60a

70a    40

(d)

70a    80a    60a    100a

40

(e)

70b    80b    60a    100b

40

# Fig. 10

ADVANCING
DIRECTION OF
FILM-SHAPED MOLD

140

ROTATION
DIRECTION
OF PRESSING
ROLL

140a

29a

30

22

23

66

70a  60a

40

TRANSPORTING DIRECTION ⟶
OF SUBSTRATE

Fig. 11

(a)

(b)

(c)

(d)

(e)

# Fig. 12

Fig. 13

# Fig. 14

(a)

d1

d2

A1

d3

L1

S

(b)

d4

d5

A2

d6

L2

S

# Fig. 15

(a)

(b)

Fig. 16

**INTERNATIONAL SEARCH REPORT**

International application No.

PCT/JP2015/059313

| A. CLASSIFICATION OF SUBJECT MATTER |
|---|
| H01L33/22(2010.01)i |

According to International Patent Classification (IPC) or to both national classification and IPC

| B. FIELDS SEARCHED |
|---|
| Minimum documentation searched (classification system followed by classification symbols) |
| H01L33/00-33/64 |

Documentation searched other than minimum documentation to the extent that such documents are included in the fields searched

| Jitsuyo Shinan Koho | 1922–1996 | Jitsuyo Shinan Toroku Koho | 1996–2015 |
|---|---|---|---|
| Kokai Jitsuyo Shinan Koho | 1971–2015 | Toroku Jitsuyo Shinan Koho | 1994–2015 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| Y | JP 2005-101566 A (Nichia Chemical Industries, Ltd.), 14 April 2005 (14.04.2005), fig. 1 & US 2005/0179130 A1 & WO 2005/018008 A1 & EP 1667241 A1 & KR 10-2006-0079196 A & TW I361534 B | 1–18 |
| Y | JP 2005-223154 A (Nichia Chemical Industries, Ltd.), 18 August 2005 (18.08.2005), fig. 6 (Family: none) | 1–18 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 29 May 2015 (29.05.15) | 09 June 2015 (09.06.15) |

| Name and mailing address of the ISA/ Japan Patent Office 3-4-3,Kasumigaseki,Chiyoda-ku, Tokyo 100-8915,Japan | Authorized officer |
|---|---|
| | Telephone No. |

Form PCT/ISA/210 (second sheet) (July 2009)

**INTERNATIONAL SEARCH REPORT**

International application No.

PCT/JP2015/059313

C (Continuation).   DOCUMENTS CONSIDERED TO BE RELEVANT

| Category* | Citation of document, with indication, where appropriate, of the relevant passages | Relevant to claim No. |
|---|---|---|
| Y | WO 2011/007878 A1  (JX Nippon Oil & Energy Corp.),<br>20 January 2011 (20.01.2011),<br>paragraphs [0006], [0027] to [0054], [0060] to [0095], [0135] to [0138]; fig. 13, 15<br>& US 2012/0132897 A1    & EP 2455786 A1<br>& CN 102472847 A         & KR 10-2012-0056822 A | 1-18 |

Form PCT/ISA/210 (continuation of second sheet) (July 2009)

**EP 3 125 312 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2010206230 A
- JP 2001210598 A
- WO 2012096368 A
- WO 2013161454 A
- WO 2011007878 A1
- JP H08112879 B
- JP H05238827 B
- JP H06122852 B
- JP H06240208 B
- JP H06299118 B
- JP H06306329 B
- JP H07196986 B

### Non-patent literature cited in the description

- *Macromolecules,* 2014, vol. 47, 2
- *Advanced Materials,* 2012, vol. 24, 5688-5694
- *Science,* 2008, vol. 322, 429
- **YOSHIDA et al.** *APPLIED PHYSICS LETTERS,* 2010, vol. 96, 211122